(19)

Europäisches Patentamt
European Patent Office
Office européen des brevets

(11) **EP 4 362 057 A1**

(12) **EUROPEAN PATENT APPLICATION**
published in accordance with Art. 153(4) EPC

(43) Date of publication:
**01.05.2024 Bulletin 2024/18**

(21) Application number: **21947230.5**

(22) Date of filing: **24.12.2021**

(51) International Patent Classification (IPC):
**H01J 37/305** *(2006.01)* **G03F 7/20** *(2006.01)*
**H01L 21/027** *(2006.01)*

(52) Cooperative Patent Classification (CPC):
**G03F 7/20; H01J 37/305; H01L 21/027**

(86) International application number:
**PCT/JP2021/048171**

(87) International publication number:
**WO 2022/269951 (29.12.2022 Gazette 2022/52)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **25.06.2021 JP 2021105443**

(71) Applicants:
• **Nippon Control System Corporation**
  **Tokyo 150-0013 (JP)**

• **IMS Nanofabrication GmbH**
  **2345 Brunn am Gebirge (AT)**

(72) Inventors:
• **HAMAJI, Masakazu**
  **Yokohama-shi, Kanagawa 222-0033 (JP)**
• **MASUMOTO, Issei**
  **Yokohama-shi, Kanagawa 222-0033 (JP)**
• **SUZUKI, Natsuki**
  **Yokohama-shi, Kanagawa 222-0033 (JP)**

(74) Representative: **Betten & Resch**
**Patent- und Rechtsanwälte PartGmbB**
**Maximiliansplatz 14**
**80333 München (DE)**

(54) **ELECTRON BEAM RENDERING DEVICE, ELECTRON BEAM RENDERING METHOD, AND RECORDING MEDIUM**

(57) Conventionally, it has not been possible to determine an appropriate emission amount at a high speed when using an electron beam to draw a figure. It is possible to acquire an appropriate emission amount at a high speed when using an electron beam to draw a figure, with an electron beam lithography apparatus including: a density set storage unit that stores, for each of one or more pieces of figure information, a set of pieces of first density information corresponding to areas occupied by a figure in two or more first small regions divided from a figure region specified by the piece of figure information; a density set acquisition unit 33 that acquires first density sets respectively corresponding to the one or more pieces of figure information from the density set storage unit; a correction amount acquisition unit that acquires correction amounts that are correction amounts corresponding to the one or more first density sets for each of the one or more pieces of figure information, and are correction amounts for the two or more second small regions; an emission amount acquisition unit that acquires, for the two or more second small regions, emission amounts of an electron beam with intensities corresponding to the correction amounts for the two or more second small regions; and a drawing unit that emits an electron beam to each of the two or more second small regions according to the emission amounts for the two or more second small regions.

**(Cont. next page)**

EP 4 362 057 A1

A

ELECTRON BEAM LITHOGRAPHY APPARATUS

1

STORAGE UNIT

11

DENSITY SET
STORAGE UNIT

12

DIFFERENTIAL INFORMATION
STORAGE UNIT

2

ACCEPTANCE UNIT

21

FIGURE INFORMATION
ACCEPTANCE UNIT

22

BIAS AMOUNT
ACCEPTANCE UNIT

4

OUTPUT UNIT

3

PROCESSING UNIT

31

FIRST
PREPROCESSING UNIT

32

SECOND
PREPROCESSING UNIT

33

DENSITY SET ACQUISITION
UNIT

331

DENSITY SET
READOUT PART

332

AREA CHANGE INFORMATION
ACQUISITION PART

333

DENSITY SET
ACQUISITION PART

34

CORRECTION AMOUNT
ACQUISITION UNIT

35

EMISSION AMOUNT
ACQUISITION UNIT

36

DRAWING UNIT

FIG.1

**Description**

Technical Field

The present invention relates to an electron beam lithography apparatus that emits an electron beam, and so on.

Background Art

Conventionally, there have been techniques for correcting the amount of a charged particle beam to be emitted from a lithography apparatus (for example, see Patent Document 1).

Citation List

Patent Document

Patent Document 1: JP 6283180B

Summary of Invention

Technical Problem

However, with conventional techniques, it has not been possible to determine an appropriate emission amount at a high speed when an electron beam is used to draw a figure. With conventional techniques, especially when the area that is influenced by the phenomenon to be corrected, such as the area that is influenced by an emitted electron beam, is wide, and when the number of figures is enormous, it takes a lot of time to determine an appropriate emission amount.

Solution to Problem

An electron beam lithography apparatus according to a first aspect of the present invention is an electron beam lithography apparatus including: a density set storage unit that stores, for each of one or more pieces of figure information, a first density set that is a set of pieces of first density information corresponding to areas occupied by a figure indicated by the piece of figure information in two or more first small regions divided from a figure region specified by the piece of figure information, and is a set of pieces of first density information for the two or more first small regions; a figure information acceptance unit that accepts one or more pieces of figure information; a density set acquisition unit that acquires first density sets respectively corresponding to the one or more pieces of figure information accepted by the figure information acceptance unit, from the density set storage unit; a correction amount acquisition unit that acquires correction amounts that are correction amounts corresponding to the one or more first density sets for each of the one or more pieces of figure information, and are correction amounts for the two or more second small regions; an emission amount acquisition unit that acquires, for the two or more second small regions, emission amounts of an electron beam with intensities corresponding to the correction amounts for the two or more second small regions acquired by the correction amount acquisition unit; and a drawing unit that emits an electron beam to each of the two or more second small regions according to the emission amounts for the two or more second small regions, acquired by the emission amount acquisition unit.

With such a configuration, it is possible to acquire an appropriate emission amount at a high speed when using an electron beam to draw a figure.

An electron beam lithography apparatus according to a second aspect of the present invention is the electron beam lithography apparatus according to the first aspect of the invention, wherein the density set acquisition unit includes: a density set readout part that acquires first density sets respectively corresponding to the one or more pieces of figure information accepted by the figure information acceptance unit, from the density set storage unit; an area change information acquisition part that acquires, for a first small region that matches a bias condition regarding a figure in the first small region, of the two or more first small regions, area change information that is based on the figure in the first small region; and a density set acquisition part that acquires, for each of the one or more pieces of figure information, a second density set that is a set of pieces of second density information respectively for the one or more first small regions, using the pieces of first density information for the one or more first small regions contained in the first density sets acquired by the density set readout part, and the area change information regarding the one or more first small regions, acquired by the area change information acquisition part, and the correction amount acquisition unit uses the one or more second density sets acquired by the density set acquisition part, to acquire the correction amounts for the two or more second small regions.

With such a configuration, it is possible to acquire a more appropriate emission amount at a high speed when using an electron beam to draw a figure.

An electron beam lithography apparatus according to a third aspect of the present invention is the electron beam lithography apparatus according to the second aspect of the invention, further including: a differential information storage unit that stores, for each of one or more pieces of figure information and for each of two or more first small regions, differential information specifying a change in an area per unit amount of bias; and a bias amount acceptance unit that accepts an amount of bias, wherein the area change information acquisition part acquires, for the first small region that matches the bias condition, area change information for each of the one or more pieces of figure information, using differential information associated with the first small region and the bias amount accepted by the bias amount acceptance unit.

With such a configuration, it is possible to acquire a more appropriate emission amount at a high speed when using an electron beam to draw a figure.

An electron beam lithography apparatus according to a fourth aspect of the present invention is the electron beam lithography apparatus according to the third aspect of the invention, further including a second preprocessing unit that calculates differential information specifying a change in an area per unit amount of bias for each of the one or more pieces of figure information and for each of the two or more first small regions, and accumulates the differential information in the differential information storage unit.

With such a configuration, it is possible to acquire a more appropriate emission amount at a high speed when using an electron beam to draw a figure.

An electron beam lithography apparatus according to a fifth aspect of the present invention is the electron beam lithography apparatus according to the fourth aspect of the invention, wherein the electron beam lithography apparatus stores a differential information calculation formula for calculating differential information, for each of one or more bias conditions, and the second preprocessing unit acquires, for each of the one or more pieces of figure information and for each of the two or more first small regions, a differential information calculation formula corresponding to the matching bias condition, calculates differential information using the differential information calculation formula, and accumulates the differential information in the differential information storage unit.

With such a configuration, it is possible to acquire a more appropriate emission amount at a high speed when using an electron beam to draw a figure.

An electron beam lithography apparatus according to a sixth aspect of the present invention is the electron beam lithography apparatus according to any one of the third to the fifth aspects of the invention, wherein the bias condition is that the figure in the first small region includes a horizontal line or a vertical line, and the area change information acquisition part acquires, with respect to the horizontal line or the vertical line, area change information indicating a size that is proportional to the bias amount.

With such a configuration, it is possible to acquire a more appropriate emission amount at a high speed when using an electron beam to draw a figure.

An electron beam lithography apparatus according to a seventh aspect of the present invention is the electron beam lithography apparatus according to any one of the third to the fifth aspects of the invention, wherein the bias condition is that the figure in the first small region includes a diagonal line, and the area change information acquisition part acquires the bias amount, angle information regarding an angle of the diagonal line, and length information regarding a length of the diagonal line in the first small region, calculates X area change information, which is area change information regarding an X component, and Y area change information, which is area change information regarding a Y component, using the bias amount, the angle information, and the length information, and calculates area change information, using the X area change information and the Y area change information.

With such a configuration, it is possible to acquire a more appropriate emission amount at a high speed when using an electron beam to draw a figure.

An electron beam lithography apparatus according to an eighth aspect of the present invention is the electron beam lithography apparatus according to any one of the third to the fifth aspects of the invention, wherein the bias condition is that the figure in the first small region includes a corner formed by an intersection of two straight lines, and the area change information acquisition part calculates areas of a parallelogram and two triangles created by extending the two straight lines by a length corresponding to the bias amount, and calculates the area change information, using the three areas.

With such a configuration, it is possible to acquire a more appropriate emission amount at a high speed when using an electron beam to draw a figure.

An electron beam lithography apparatus according to a ninth aspect of the present invention is the electron beam lithography apparatus according to any one of the first to the eighth aspects of the invention, further including a first preprocessing unit that acquires, for each of two or more first small regions divided from a figure region that is a region specified by the figure information, first density information that is based on areas occupied by a figure indicated by the figure information, in the two or more first small regions, acquires a first density set that is a set of pieces of first density information, for each piece of figure information, and accumulates the first density set in the density set storage unit.

With such a configuration, it is possible to acquire a more appropriate emission amount at a high speed when using an electron beam to draw a figure.

A density set production apparatus according to a tenth aspect of the present invention is a density set production apparatus including: a figure information acceptance unit that accepts one or more pieces of figure information; and a first preprocessing unit that acquires, for each of two or more first small regions divided from a figure region that is a region specified by the figure information, first density information that is based on areas occupied by a figure indicated by the figure information, in the two or more first small regions, acquires a first density set that is a set of pieces of first density information, for each piece of figure information, and accumulates the first density set.

With such a configuration, it is possible to acquire and accumulate density sets.

A differential information set production apparatus according to an eleventh aspect of the present invention is a differential information set production apparatus including: a figure information acceptance unit that accepts one or more pieces of figure information; and a second preprocessing unit that calculates differential information specifying a change in an area per unit amount of bias for each of the one or more pieces of figure information and for each of two or more first small regions, and accumulates the differential information.

With such a configuration, it is possible to acquire and accumulate differential information sets.

Advantageous Effects of Invention

With the electron beam lithography apparatus according to the present invention, it is possible to acquire an appropriate emission amount at a high speed when using an electron beam to draw a figure.

Brief Description of Drawings

FIG. 1 is a block diagram for an electron beam lithography apparatus A according to a first embodiment.
FIG. 2 is a diagram illustrating the derivation of an example of a differential information calculation formula according to the same.
FIG. 3 is a diagram illustrating the derivation of an example of a differential information calculation formula according to the same.
FIG. 4 is a diagram illustrating the derivation of an example of a differential information calculation formula according to the same.
FIG. 5 is a diagram illustrating the derivation of an example of a differential information calculation formula according to the same.
FIG. 6 is a diagram illustrating the derivation of an example of a differential information calculation formula according to the same.
FIG. 7 is a flowchart illustrating examples of operations of the electron beam lithography apparatus A according to the same.
FIG. 8 is a flowchart illustrating an example of density information acquisition processing according to the same.
FIG. 9 is a flowchart illustrating an example of differential information acquisition processing according to the same.
FIG. 10 is a flowchart illustrating an example of density set acquisition processing according to the same.
FIG. 11 is a flowchart illustrating an example of correction amount set acquisition according to the same.
FIG. 12 is a flowchart illustrating an example of drawing processing according to the same.
FIG. 13 is a diagram illustrating processing that is performed by a first preprocessing unit 31 according to the same.
FIG. 14 is a diagram showing an example of a first density map according to the same.
FIG. 15 is a diagram illustrating processing that is performed by a second preprocessing unit 32 according to the same.
FIG. 16 is a diagram showing an example of a differential information set according to the same.
FIG. 17 is a block diagram for a density set production apparatus B.
FIG. 18 is a block diagram for a differential information set production apparatus C.
FIG. 19 is an overview of a computer system according to the same.
FIG. 20 is a block diagram for the computer system according to the same.

Description of Embodiments

Hereinafter, embodiments of an electron beam lithography apparatus and so on will be described with reference to the drawings. Note that the constituent elements with the same reference numerals perform the same operations in the embodiment, and therefore redundant descriptions thereof may be omitted.

First Embodiment

In the present embodiment, for each of two or more first small regions obtained by dividing a region containing one or more pieces of figure information, first density information corresponding to areas occupied by a figure is acquired, and a set of pieces of first density information associated with the first small region identifiers is stored in advance. The present embodiment describes an electron beam lithography apparatus that uses the set of pieces of first density information for each of the one or more pieces of figure information to acquire a set of correction amounts for each second small region, determines, for each second small region, the amount of emission of an electron beam based on the correction amount corresponding thereto, and emits an electron beam according to the emission amount.

The present embodiment also describes an electron beam lithography apparatus that performs bias processing to create a set of more appropriate correction amounts, determines the emission amount of an electron beam based on the set of correction amounts, and emits an electron beam according to the emission amount.

The present embodiment also describes an electron beam lithography apparatus that stores, in advance, for each first small region, differential information that is information regarding a change in the area per unit amount of bias, uses the differential information to create a set of more appropriate correction amounts, determines the emission amount of an electron beam based on the set of correction amounts, and emits an electron beam according to the emission amount.

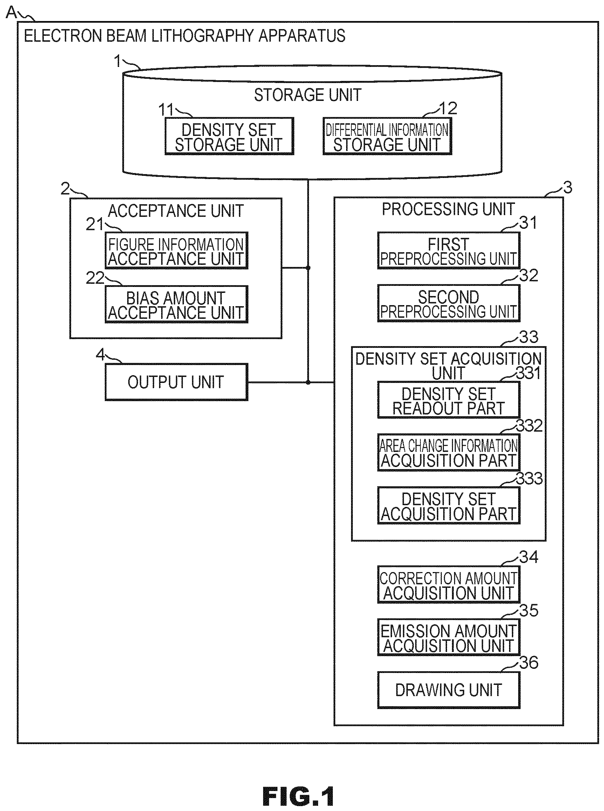

FIG. 1 is a block diagram for an electron beam lithography apparatus A according to the present embodiment. The electron beam lithography apparatus A includes a storage unit 1, an acceptance unit 2, a processing unit 3, and an output unit 4.

The storage unit 1 includes a density set storage unit 11, and a differential information storage unit 12. The acceptance unit 2 includes a figure information acceptance unit 21 and a bias amount acceptance unit 22. The processing unit 3 includes a first preprocessing unit 31, a second preprocessing unit 32, a density set acquisition unit 33, a correction amount acquisition unit 34, an emission amount acquisition unit 35, and a drawing unit 36. The density set acquisition unit 33 includes a density set readout part 331, an area change information acquisition part 332, and a density set acquisition part 333.

The storage unit 1 stores various kinds of information. Examples of the various kinds of information include a density set, which will be described later, differential information, which will be described later, one or more pieces of figure information, one or more bias conditions, one or more differential information calculation formulas, and various arithmetic expressions, which will be described later.

Each piece of figure information is information indicating a figure. Each piece of figure information is, for example, a set of pieces of coordinate information regarding two or more points that make up a figure. Each piece of figure information is, for example, a set of pieces of information regarding three or more lines that make up a figure. Figure information is, for example, a file. However, there is no limitation on the structure of figure information. In addition, each piece of figure information is associated with a figure identifier. The figure identifier is information identifying a figure, and is, for example, an ID, a file name, or a figure name.

The bias conditions are conditions for acquiring area change information, which will be described later. The bias conditions are usually conditions regarding the figures of the first small regions. A bias condition is, for example, that the first small regions include a region that contains a figure and a region that does not contain a figure. A bias condition is, for example, that a first small region contains a line of a figure. Note that a line of a figure is a boundary of the figure. A bias condition is, for example, that a first small region contains a horizontal line of a figure. A bias condition is, for example, that a first small region contains a vertical line of a figure. A bias condition is, for example, that a first small region contains a diagonal line of a figure. A bias condition is, for example, that a first small region contains a corner of a figure. A corner is formed by the intersection of two straight lines.

Each first small region may contain a part of a figure, or may contain one or more figures.

The differential information calculation formula is an arithmetic expression for calculating differential information. The differential information calculation formula is usually associated with a bias condition. Specific examples of differential information calculation formulas will be described later.

The density set storage unit 11 stores a first density set for each of one or more pieces of figure information. The one or more first density sets are, for example, associated with figure identifiers intensifying pieces of figure information.

Each first density set contains two or more pieces of first density information. Each first density set is a set of pieces of first density information for two or more first small regions. Each first density set is, for example, constituted by two or more pieces of first density pair information. Each piece of first density pair information is a pair of a first small region identifier identifying a first small region, and a piece of first density information. Note that a first density set may also be referred to as a first density map.

Each piece of first density information is, for example, associated with a first small region identifier. Each piece of first density information is, for example, associated with region information (for example, information containing upper left and lower right coordinates) specifying a first small region. Each piece of first density information is information corresponding to the area of the portion contained in the first small region of the figure indicated by the figure information. Each piece of first density information is, for example, information regarding the density of the figure in the first small region. Each piece of first density information is, for example, information regarding the proportion of the figure in the total area of the first small region. Each piece of first density information is, for example, a numerical value between 0 and 1. Each piece of first density information is, for example, information regarding the area occupied by the figure in the first small region. Each piece of first density information may indicate the area occupied by the figure in the first small region.

It is preferable that the one or more first density sets in the density set storage unit 11 are pieces of information acquired by the first preprocessing unit 31. It is preferable that the one or more first density sets in the density set storage unit 11 are pieces of information accumulated in the density set storage unit 11 through the processing performed by the first preprocessing unit 31 as preprocessing before an instruction to start drawing is accepted.

Note that the two or more first small regions may have different sizes and shapes. Further, as a result of the division method being different depending on the figure information, the first small regions may have different sizes and shapes depending on the figure information. However, it is preferable that the shape is rectangular.

The differential information storage unit 12 stores pieces of differential information associated with first small regions. The differential information storage unit 12 stores, for example, pieces of differential information associated with one or more first small regions.

The differential information storage unit 12 stores a differential information set for each of one or more pieces of figure information. The differential information sets in the differential information storage unit 12 are associated with figure identifiers, for example.

Each differential information set is a set of one or more pieces of differential information. Each piece of differential information in each differential information set corresponds to a first small region. Each piece of differential information in each differential information set is, for example, associated with a first small region identifier. Each piece of differential information in each differential information set is, for example, associated with a first small region identifier.

Each piece of differential information is information specifying the change in the area per unit amount of bias. The unit amount is, for example, 1 nm, but there is no limitation. Note that "bias" refers to moving and correcting part or all of the contour that makes up the original figure when a pattern is not formed as designed through a manufacturing process such as drawing, development after drawing, or etching.

It is preferable that the one or more pieces of differential information in the differential information storage unit 12 are pieces of information acquired by the second preprocessing unit 32. It is preferable that the one or more pieces of differential information in the differential information storage unit 12 are pieces of information accumulated in the differential information storage unit 12 through the processing performed by the second preprocessing unit 32 as preprocessing in advance to the instruction to start drawing.

The acceptance unit 2 accepts various kinds of information and instructions. Examples of the various kinds of information and instructions include figure information, which will be described later, a bias amount, which will be described later, a preprocessing instruction, and a start instruction.

The preprocessing instruction is an instruction to perform preprocessing on one or more pieces of figure information. Preprocessing is processing that is performed before a drawing start instruction is accepted. Preprocessing is, for example, processing that is performed by the first preprocessing unit 31 to acquire a density set. Preprocessing is, for example, processing that is performed by the second preprocessing unit 32 to acquire differential information.

The start instruction is an instruction to start drawing a figure. It is preferable that the start instruction contains one or more pieces of figure information.

The "acceptance" here means, for example, to acquire information acquired by a processing part (not shown), from the processing part. In addition, the "acceptance" here may be a concept that includes reception of information transmitted via a wired or wireless communication network, acceptance of information read from a recording medium such as an optical disk, a magnetic disk, or a semiconductor memory, acceptance of information input from an input device such as a keyboard, a mouse, or a touch panel, and so on. That is to say, there is no limitation on the means by which the information or an instruction to be accepted is accepted.

The figure information acceptance unit 21 accepts one or more pieces of figure information. The figure information acceptance unit 21 may acquire the one or more pieces of figure information contained in the start instruction accepted by the acceptance unit 2. The figure information acceptance unit 21 may acquire one or more pieces of figure information from the storage unit 1.

The bias amount acceptance unit 22 accepts a bias amount. For example, the bias amount acceptance unit 22 may accept a bias amount from a user. However, there is no limitation on the method by which a bias amount is accepted.

In addition, the bias amount acceptance unit 22 may accept a different bias amount for each piece of figure information. In addition, the bias amount acceptance unit 22 may accept a different bias amount for each of the one or more figures contained in figure information. In addition, the bias amount acceptance unit 22 may accept a different bias amount for each component (for example, a line segment) forming a figure. Furthermore, the bias amount acceptance unit 22 may accept a different bias amount for each portion of each component (for example, a line segment) forming a figure.

The processing unit 3 performs various kinds of processing. Examples of the various kinds of processing include processing that is performed by the first preprocessing unit 31, processing that is performed by the second preprocessing unit 32, processing that is performed by the density set acquisition unit 33, processing that is performed by the correction amount acquisition unit 34, and processing that is performed by the emission amount acquisition unit 35.

The processing unit 3 changes figure information based on the bias information accepted by the bias amount acceptance unit 22. Such processing is referred to as bias processing.

The first preprocessing unit 31 acquires density information for each of two or more first small regions divided from a region that includes a figure region, which is region specified by figure information. Thereafter, the first preprocessing unit 31 acquires a density set, which is a set of the pieces of density information regarding the two or more first small regions, and accumulates the density set in the density set storage unit 11. Note that there is no limitation on the size of each first small region.

It is preferable that the first preprocessing unit 31 acquires a density set for the one or more pieces of figure information that can be accepted by the figure information acceptance unit 21, and accumulates the density set in the density set storage unit 11 in association with the pieces of figure information. That is to say, it is preferable that the first preprocessing unit 31 operates before the drawing unit 36 performs processing, to accumulate the density set in the density set storage unit 11 in association with the one or more pieces of figure information. Such preprocessing reduces the processing time from when the figure information acceptance unit 21 receives figure information until the drawing unit 36 performs processing.

For example, the first preprocessing unit 31 acquires, for each first small region of the figure information, the area of figure information contained in the first small region, from the figure information. Thereafter, the first preprocessing unit 31 acquires the density information of the first small region using, for example, an increasing function that employs the area as a parameter. Note that the first preprocessing unit 31 acquires, for example, the area of the entire first small region, and acquires density information that is the ratio of the area indicated by the figure information to the entire area. The first preprocessing unit 31 acquires density information using, for example, an arithmetic expression "the density information = the area of the figure in the first small region divided by the area of the entire first small region". The first preprocessing unit 31 may acquire the area of the figure in the first small region per se as density information.

Note that, if there are two or more figures in the first small region, the first preprocessing unit 31 acquires the area of the first small region in each of the plurality of figures, and acquires the sum of the two or more areas. Thereafter, the first preprocessing unit 31 acquires the density information of the first small region using an increasing function that employs the sum of the two or more areas as a parameter. The first preprocessing unit 31 acquires density information using, for example, an arithmetic expression "the density information = the sum of the two or more areas divided by the area of the entire first small region". The first preprocessing unit 31 may acquire the sum of the two or more areas as density information.

The second preprocessing unit 32 calculates, for each of one or more pieces of figure information, pieces of differential information associated with the two or more first small regions, and accumulates the pieces of differential information in the differential information storage unit 12. Note that differential information is information specifying the change in the area per unit amount of bias in the first small region.

For example, the second preprocessing unit 32 accumulates the calculated differential information in association with the figure identifier and the first small region identifier.

For example, the second preprocessing unit 32 acquires, for each of the one or more pieces of figure information and for each of the two or more first small regions, a differential information calculation formula corresponding to the matching bias condition, from the storage unit 1, calculates differential information using the differential information calculation formula, and accumulates the differential information in the differential information storage unit 12.

Hereinafter, four cases in which the second preprocessing unit 32 calculates differential information will be described using examples of differential information calculation formulas for each case. The four cases are (1) when the first small region contains a horizontal line, (2) when the first small region contains a vertical line, (3) when the first small region contains a diagonal line, and (4) when the first small region contains a corner.

(1) When the first small region contains a horizontal line

The second preprocessing unit 32 calculates, for each of one or more pieces of figure information and for each of the two or more first small regions, the length ($L_1$) of the horizontal line of the figure in the first small region, using region information regarding the first small region and the piece of figure information. Next, for each of the one or more pieces of figure information and for each of the two or more first small regions, the second preprocessing unit 32 reads out a constant ($\alpha_1$) that is stored in the storage unit 1, and substitutes $\alpha_1$ and $L_1$ into Formula 1 shown below and executes Formula 1 to obtain differential information. Next, for each of the one or more pieces of figure information and for each of the two or more first small regions, the second preprocessing unit 32 accumulates the differential information in the differential information storage unit 12 in association with the figure identifier and the first small region identifier.

[Math. 1]

$$\text{Differential information} = \alpha_1 \times L_1$$

In Formula 1, $\alpha_1$ is a constant and $L_1$ is the length of the horizontal line of the first small region.

In addition, the differential information calculation formula in the case (1) is not limited to Formula 1. The differential information calculation formula in the case (1) need only be an increasing function that employs the length of the horizontal line ($L_1$) as a parameter.

In addition, when a plurality of horizontal lines are present in one first small region, the second preprocessing unit 32 calculates differential information for each horizontal line, and calculates the sum of the pieces of differential information of the horizontal lines. Such a sum is differential information of the one first small region.

(2) When the first small region contains a vertical line

The second preprocessing unit 32 calculates, for each of one or more pieces of figure information and for each of the two or more first small regions, the length ($L_2$) of the vertical line of the figure in the first small region, using region information regarding the first small region and the piece of figure information. Next, for each of the one or more pieces of figure information and for each of the two or more first small regions, the second preprocessing unit 32 reads out a constant ($\alpha_2$) that is stored in the storage unit 1, and substitutes $\alpha_2$ and $L_2$ into Formula 2 shown below and executes Formula 1 to obtain differential information. Next, for each of the one or more pieces of figure information and for each of the two or more first small regions, the second preprocessing unit 32 accumulates the differential information in the differential information storage unit 12 in association with the figure identifier and the first small region identifier.

[Math. 2]

$$\text{Differential information} = \alpha_2 \times L_2$$

In Formula 2, $\alpha_2$ is a constant and $L_2$ is the length of the horizontal line of the first small region.

In addition, the differential information calculation formula in the case (2) is not limited to Formula 2. The differential information calculation formula in the case (2) need only be an increasing function that employs the length of the vertical line ($L_2$) as a parameter.

In addition, when a plurality of vertical lines are present in one first small region, the second preprocessing unit 32 calculates differential information for each vertical line, and calculates the sum of the pieces of differential information of the vertical lines. Such a sum is differential information of the one first small region.

(3) When the first small region contains n diagonal lines.

For each of one or more piece of figure information and for each of two or more first small regions, the second preprocessing unit 32 calculates the length ($L_i$) of each diagonal line in the first small region, using the region information regarding the first small region and the piece of figure information. Next, for each of one or more piece of figure information and for each of two or more first small regions, the second preprocessing unit 32 acquires the normal angle ($\alpha_i$) of each diagonal line. Next, the second preprocessing unit 32 substitutes $L_i$ and $\alpha_i$ of each diagonal line into Formulas 3 shown below and executes Formulas 3 to obtain differential information. Next, for each of the one or more pieces of figure information and for each of the two or more first small regions, the second preprocessing unit 32 accumulates the differential information in the differential information storage unit 12. For example, the second preprocessing unit 32 stores differential information in the differential information storage unit 12 in association with the figure identifier and the first small region identifier.

[Math. 3]

$$D_x = \sum_{i=0}^{n} L_i \cos^2 \alpha_i \ , \quad D_y = \sum_{i=0}^{n} L_i \sin^2 \alpha_i$$

In Formulas 3, $D_x$ denotes information regarding the area increase amount of the X component. $D_y$ denotes information regarding the area increase amount of the Y component. $L_i$ denotes the length of the diagonal line. $\alpha_i$ denotes the angle of the normal line of the diagonal line.

In addition, the differential information calculation formula in the case (3) is not limited to Formulas 3. The differential information calculation formula in the case (3) need only be an increasing function that employs the length of the diagonal line ($L_i$) as a parameter.

The process of deriving the above Formulas 3 will be described below.

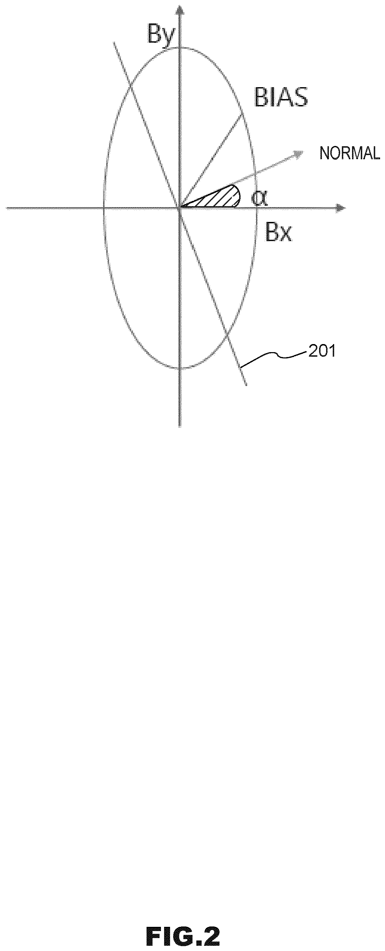

Even in cases where anisotropic sizing is required, the amount of bias typically changes continuously. In other words, in most cases, it is desired to apply similar amounts of bias to line segments with similar angles. Therefore, the amount of bias corresponding to the angle of the line segment is defined using an ellipse, as shown in FIG. 2. It is assumed that an amount of bias ($B_x$,$B_y$) in the X direction (the horizontal line) and the Y direction (the vertical line) are given. As a result, the amount of bias (BIAS) is calculated using Formula 4. Note that a denotes the angle of the normal line to the diagonal line 201 (see FIG. 2).

[Math. 4]

$$BIAS = \begin{pmatrix} B_x \cos \alpha \\ B_y \sin \alpha \end{pmatrix}$$

According to Formula 4, the direction of the bias vector deviates from the normal direction. However, if the actual bias direction is set to the normal direction, the change in the area can be decomposed into an X component and a Y component as shown below (see Formulas 5). This matches the method in which the user specifies only $B_x$ and $B_y$.

[Math. 5]

$$\Delta Area_x = |L_{edge}| \cos^2 \theta$$

$$\Delta Area_y = |L_{edge}| \sin^2 \theta$$

$$\Delta Area = \Delta Area_x + \Delta Area_y$$

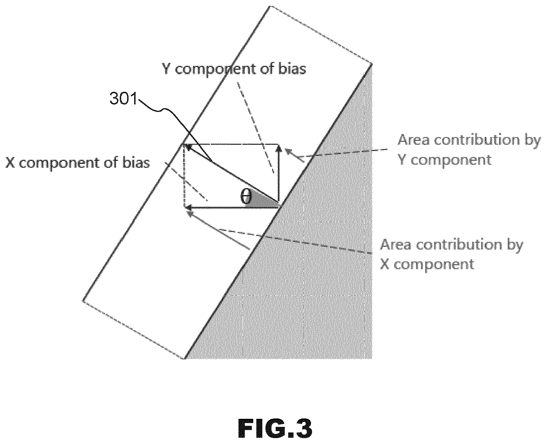

Note that in Formula 5, $\Delta Area_x$ denotes the X component of the change in the area. $\Delta Area_y$ denotes the Y component of the change in the area. $L_{edge}$ denotes the length of the diagonal line 301 in FIG. 3. $\theta$ in FIG. 3 denotes the angle of the diagonal line with respect to the horizontal line.

From the above, when the bias vector is a projection of the bias vector given by the elliptic formula in the normal direction, then the amount of bias is expressed by the following Formula 6.

[Math. 6]

$$BIASamount = \begin{pmatrix} \cos \alpha \\ \sin \alpha \end{pmatrix} \cdot \begin{pmatrix} B_x \cos \alpha \\ B_y \sin \alpha \end{pmatrix}$$

Here, the change in the area caused by the straight line having the length L can be expressed by the following Formulas 7.

[Math. 7]

$$\Delta Area_x = LB_x \cos^2 \alpha$$

$$\Delta Area_y = LB_y \sin^2 \alpha$$

$$\Delta Area = \Delta Area_x + \Delta Area_y$$

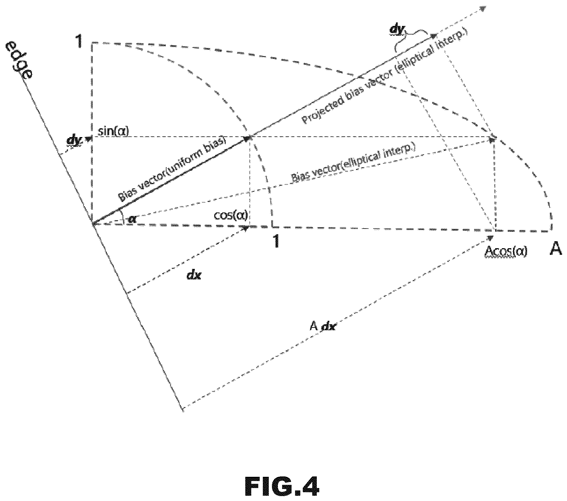

Here, L and $\alpha$ are data specific to line segments. Therefore, when the length of the target $i^{th}$ diagonal line segment and the angle of the normal are Li and oi, respectively, the change in the area for a group of line segments can be expressed by the following Formula 8 (see FIG. 4). Note that in FIG. 4, $B_x$ = A and $B_y$ = 1 are satisfied.

[Math. 8]

$$B_x \sum_{i=0}^{n} L_i \cos^2 \alpha_i + B_y \sum_{i=0}^{n} L_i \sin^2 \alpha_i$$

Therefore, the differential value (differential information) of the total of the changes in the areas for a group of line segments can be defined by the above Formulas 3.

(4) When the first small region contains N corners

For each of the one or more pieces of first small region, for each of the two or more first small regions, and for each corner, the second preprocessing unit 32 acquires all of the parameters used in Formula 9. Next, for each of the one or more pieces of first small region, for each of the two or more first small regions, and for each corner, the second preprocessing unit 32 substitute all the parameters into Formula 9 and executes Formula 9 to obtain differential information. Next, for each of the one or more pieces of figure information, for each of the two or more first small regions, and for each corner, the second preprocessing unit 32 calculates differential information and accumulates the differential information in the differential information storage unit 12.

Note that, for example, for each of the one or more pieces of figure information and for each of the two or more first small regions, the second preprocessing unit 32 calculates the sum of the calculated one or more pieces of differential information, and accumulates the sum of the one or more pieces of differential information in the differential information storage unit 12 in association with the figure identifier and the first small region identifier. Such a sum is differential information for each of the one or more pieces of figure information, for each of the two or more first small regions, and for each corner.

[Math. 9]

$$\sum_{i=0}^{N} S_i = B_x^2 \sum d_{xxi} + B_x B_y \sum d_{xyi} + B_y^2 \sum d_{yyi}$$

Note that the first term on the right side of Formula 9 is the area of a triangle T21. The second term is the area of a parallelogram P. The third term is the area of a triangle T12. In addition, Formula 9 ...

The process of deriving the above Formula 9 will be described below.

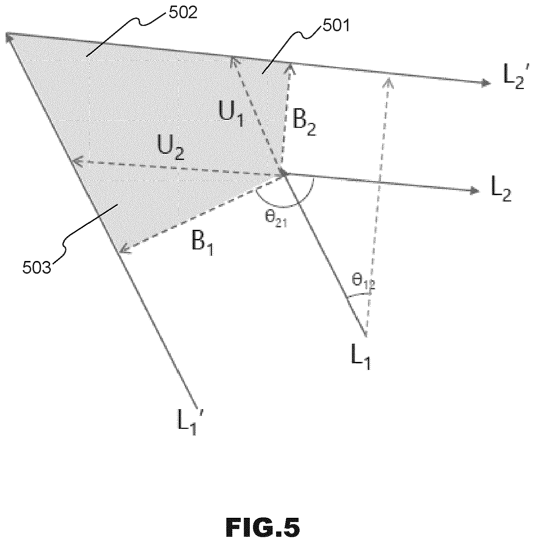

Here, consideration is given to shapes (shaded areas 501, 502, and 503 in FIG. 5) at the corner obtained as a result of applying biases respectively represented by bias vectors $B_1$ and $B_2$ to the line segments $L_1$ and $L_2$ of the corner formed by the line segments $L_1$ and $L_2$, which are represented as two unit vectors as shown in FIG. 5.

$U_1$ represents a vector from the vertex of $L_1$ to $L_2$' in the direction of the $L_1$ vector. $U_2$ represents a vector from the vertex of $L_2$ to $L_1$' in the direction of the $L_2$ vector.

Here, when the angle formed by $L_1$ and $B_2$ is $\theta_{12}$, $U_1$ is expressed by the following formula 10 ($L_1$ is a unit vector).

[Math. 10]

$$U_1 = \frac{|B_2|}{|L_1| \cos \theta_{12}} L_1 = \frac{|B_2|}{\cos \theta_{12}} L_1$$

Similarly, $U_2$ is expressed by the following Formula 11 ($L_2$ is a unit vector).

[Math. 11]

$$U_2 = \frac{|B_1|}{\cos \theta_{21}} L_2$$

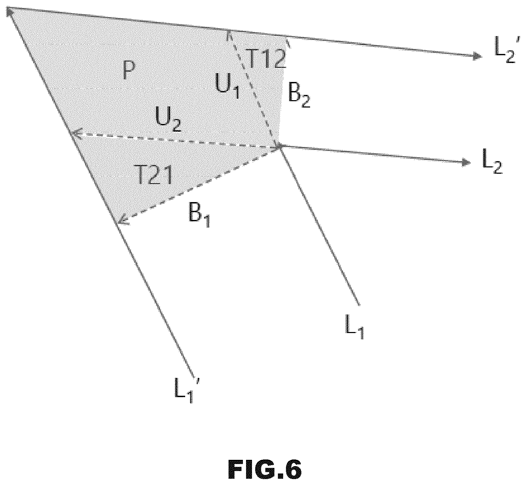

Now that $U_1$ and $U_2$ have been determined, the increase in the area of the corner is calculated by dividing the corner into the parallelogram P made up of $U_1$ and $U_2$, the triangle T12 made up of $U_1$ and $B_2$, and the triangle T21 made up of $U_2$ and $B_1$ (see FIG. 6).

P is calculated using the following Formula 12, using $U_1$ and $U_2$.

[Math. 12]

$$P = |U_1 \times U_2| = \frac{|B_1||B_2|}{\cos \theta_{12} \cos \theta_{21}} |L_1 \times L_2|$$

T12 and T21 are also calculated using Formulas 13 and 14, respectively, using the cross product.

[Math. 13]

$$T_{12} = \frac{|U_1 \times B_2|}{2} = \frac{|B_2|}{2 \cos \theta_{12}} \, |L_1 \times B_2| = \frac{|B_2|^2 \sin \theta_{12}}{2 \cos \theta_{12}}$$

[Math. 14]

$$T_{21} = \frac{|U_2 \times B_1|}{2} = \frac{|B_1|}{2 \cos \theta_{21}} \, |L_2 \times B_1| = \frac{|B_1|^2 \sin \theta_{21}}{2 \cos \theta_{21}}$$

When the components that do not depend on the biases B1 and B2 are set as shown in Formulas 15, the area of the corner is as expressed by the following Formula 16.

[Math. 15]

$$C_{12} = \frac{|L_1 \times L_2|}{\cos \theta_{12} \cos \theta_{21}}$$

$$C_{11} = \frac{\sin \theta_{21}}{2 \cos \theta_{21}}$$

$$C_{22} = \frac{\sin \theta_{12}}{2 \cos \theta_{12}}$$

[Math. 16]

$$S = T_{21} + P + T_{12} = C_{11}|B_1|^2 + C_{12} \, |B_1||B_2| + C_{22}|B_2|^2$$

Here, the magnitudes $B_1$ and $B_2$ of the bias vectors are expressed by Formulas 17, where the angles in the normal direction of $L_1$ and $L_2$ are $\Phi_1$ and $\Phi_2$.

[Math. 17]

$$|B_1| = B_x \cos^2 \varphi_1 + B_y \sin^2 \varphi_1$$

$$|B_2| = B_x \cos^2 \varphi_2 + B_y \sin^2 \varphi_2$$

Formulas 17 can be transformed into Formulas 18.

[Math. 18]

$$|B_1|^2 = B_x^2 \cos^4 \varphi_1 + 2B_x B_y \cos^2 \varphi_1 \sin^2 \varphi_1 + B_y^2 \sin^4 \varphi_1$$

$$|B_2|^2 = B_x^2 \cos^4 \varphi_2 + 2B_x B_y \cos^2 \varphi_2 \sin^2 \varphi_2 + B_y^2 \sin^4 \varphi_2$$

$$|B_1||B_2| = B_x^2 \cos^2 \varphi_1 \cos^2 \varphi_2 + B_x B_y (\cos^2 \varphi_1 \sin^2 \varphi_2 + \cos^2 \varphi_2 \sin^2 \varphi_1) + B_y^2 \sin^2 \varphi_1 \sin^2 \varphi_2$$

[Math. 19]

$$d_{xx} = C_{11} \cos^4 \varphi_1 + C_{12} \cos^2 \varphi_1 \cos^2 \varphi_2 + C_{22} \cos^4 \varphi_2$$

$$d_{yy} = C_{11} \sin^4 \varphi_1 + C_{12} \sin^2 \varphi_1 \sin^2 \varphi_2 + C_{22} \sin^4 \varphi_2$$

$$d_{xy} = C_{11} \cos^2 \varphi_1 \sin^2 \varphi_1 + C_{12}(\cos^2 \varphi_1 \sin^2 \varphi_2 + \cos^2 \varphi_2 \sin^2 \varphi_1) + C_{22} \cos^2 \varphi_2 \sin^2 \varphi_2$$

Here, when $D_{xx}$, $D_{yy}$, and $D_{xy}$ are defined as in Formulas 19, the area of the corner is expressed by the following Formulas 20.

[Math. 20]

$$|B_1|^2 = B_x^2 \cos^4 \varphi_1 + 2B_x B_y \cos^2 \varphi_1 \sin^2 \varphi_1 + B_y^2 \sin^4 \varphi_1$$

$$|B_2|^2 = B_x^2 \cos^4 \varphi_2 + 2B_x B_y \cos^2 \varphi_2 \sin^2 \varphi_2 + B_y^2 \sin^4 \varphi_2$$

$$|B_1||B_2| = B_x^2 \cos^2 \varphi_1 \cos^2 \varphi_2 + B_x B_y (\cos^2 \varphi_1 \sin^2 \varphi_2 + \cos^2 \varphi_2 \sin^2 \varphi_1) + B_y^2 \sin^2 \varphi_1 \sin^2 \varphi_2$$

In Formulas 20, $D_{xx}$, $D_{yy}$, and $D_{xy}$ are pieces of information that do not depend on the bias and can be calculated only from figure information, and therefore the total area of the corners of a certain figure group including N vertices is given by the above Formula 9.

When a plurality of types of figures are included in one first small region, the second preprocessing unit 32 calculates a piece of differential information for each type of figure, and calculates the sum of the pieces of differential information for the types. Thereafter, the second preprocessing unit 32 accumulates the sum of the pieces of differential information in the differential information storage unit 12 as differential information regarding the one first small region.

Note that the second preprocessing unit 32 does not necessarily perform the above calculation.

For example, the density set acquisition unit 33 acquires the first density set corresponding to the figure information accepted by the figure information acceptance unit 21, from the density set storage unit 11. For example, the density set acquisition unit 33 acquires the first density set corresponding to the two or more pieces of figure information accepted by the figure information acceptance unit 21, from the density set storage unit 11. Note that such a density set may be referred to as a second density set, which will be described later. In such a case, correction using the bias amount will not be performed.

For example, the density set acquisition unit 33 acquires the first density set, which is a density set corresponding to the figure information accepted by the figure information acceptance unit 21, from the density set storage unit 11, and acquires a second density set, using the first density set.

The density set readout part 331 included in the density set acquisition unit 33 acquires the first density set, which is a density set corresponding to the figure information accepted by the acceptance unit 2, from the density set storage unit 11. The density set readout part 331 acquires the first density set corresponding to the two or more pieces of figure information accepted by the acceptance unit 2, from the density set storage unit 11.

The area change information acquisition part 332 acquires area change information that is based on the figure in the first small region that matches the bias conditions, of the two or more first small regions corresponding to the figure information accepted by the acceptance unit 2. Note that bias conditions are stored in the storage unit 1.

For example, the area change information acquisition part 332 acquires area change information for the first small region that matches the bias conditions, using the differential information associated with the first small region and the bias amount accepted by the bias amount acceptance unit 22. For example, the area change information acquisition part 332 acquires, for the first small region that matches the bias conditions, the differential information associated with the first small region, from the differential information storage unit 12, and calculates area change information, which is the product of the differential information and the bias amount accepted by the bias amount acceptance unit 22.

For example, with respect to a horizontal line or a vertical line of the figure in the first small region, the area change information acquisition part 332 acquires area change information indicating a size that is proportional to the bias amount.

The area change information acquisition part 332 acquires a bias amount, angle information regarding the angle of the diagonal line, and length information regarding the length of the diagonal line within the first small region, calculates X area change information, which is area change information regarding the X component, and Y area change information, which is area change information regarding the Y component, using the bias amount, the angle information, and the length information, and calculates area change information, using the X area change information and the Y area change information. For example, the area change information acquisition part 332 calculates area change information, using an increasing function that employs the X area variation information and the Y area variation information as parameters. Note that the increasing function is, for example, a function that calculates a sum.

The area change information acquisition part 332 calculates the areas of a parallelogram and two triangles created by extending two straight lines by a length corresponding to the bias amount, and calculate area change information using the three areas. For example, the area change information acquisition part 332 calculates area change information, using an increasing function that employs the three areas as parameters. Note that the increasing function is a function that calculates a sum.

The density set acquisition part 333 acquires a second density set corresponding to one or more pieces of figure information, using the first density set acquired by the density set readout part 331 and the area change information regarding one or more first small regions acquired by the area change information acquisition part 332.

For example, for each of one or more pieces of figure information and for each of two or more small regions, the density set acquisition part 333 acquires first density information and area change information, and for each piece of figure information and each small region, the density set acquisition part 333 calculates second density information, using an increasing function that employs the first density set and the area change information as parameters. For example, for each piece of figure information, the density set acquisition part 333 acquires a second density set, which is a set of pieces of second density information corresponding to two or more small regions. Note that the increasing function is a function that calculates a sum.

The correction amount acquisition unit 34 acquires correction amounts for two or more second small regions, which are correction amounts corresponding to one or more first density sets for one or more pieces of figure information. The set of correction amounts for the two or more second small regions is referred to as a correction amount set or a correction map. The correction amount acquisition unit 34 may acquire two or more correction maps. The correction amount acquisition unit 34 may acquire a correction map for each of two or more correction types. Examples of the correction types include...

For example, the correction amount acquisition unit 34 acquires correction amounts for two or more second small regions, using one or more second density sets. Note that each second small region may be the same as any of the first small regions, or include two or more first small regions, or a portion of any of the first small regions, or a portion of two or more first small regions. That is to say, there is no limitation on the relationship between the second small regions and the first small regions. The second small regions and the first small regions may be regions having different sizes.

The correction amount acquisition unit 34 may acquires correction amounts for two or more second small regions using the density set for two or more pieces of figure information. Note that the density set here may be the first density set or the second density set.

For example, for each second small region, the correction amount acquisition unit 34 calculates a correction amount, using an increasing function that employs first density information regarding one or more first small regions corresponding to the second small region, as a parameter. Note that the increasing function is a function that calculates a sum. Note that the first small region corresponding to a second small region is a first small region at least a portion of which is included in the second small region.

It is preferable that the correction amount acquisition unit 34 uses the one or more second density sets acquired by the density set acquisition part 333, to acquire correction amounts for two or more second small regions.

For example, for each second small region, the correction amount acquisition unit 34 calculates a correction amount, using an increasing function that employs second density information regarding one or more first small regions corresponding to the second small region, as a parameter. Note that the increasing function is a function that calculates a sum.

The correction amount acquisition unit 34 may use information other than the first density set or the second density set to acquire the correction amounts for the second small regions. For example, the correction amount acquisition unit 34 calculates the correction amounts, using a table of correction amounts calculated in advance for each of the positions of the figures, each of the types of the figures, and each of the sizes of the figures, or the amount of emitted beam, or, for density-dependent phenomena such as development and etching, a combination of parameters for a model that expresses phenomena such as a Gaussian kernel, and a second density set or characteristic information regarding processes such as Coulomb scattering of the drawing beam or scattering in a sample.

For example, it is preferable that the correction amount acquisition unit 34 uses the acquired bias amounts to acquire correction amounts. Note that the bias amounts may be stored in the storage unit 1 in advance, or accepted by the acceptance unit 2, for example.

The emission amount acquisition unit 35 acquires the emission amounts of the electron beam with intensities corresponding to the correction amounts for the two or more second small regions acquired by the correction amount acquisition unit 34, for each of the two or more second small regions.

For example, the emission amount acquisition unit 35 calculates an emission amount for each second small region, using an increasing that employs correction amount for the two or more second small regions acquired by the correction amount acquisition unit 34 as parameters.

The emission amount acquisition unit 35 may use information other than correction amounts for the second small regions, to determine the emission amounts. For example, the emission amount acquisition unit 35 may determine the emission amounts by combining the correction amounts for a phenomenon with an influence range that is equal to or smaller than that of the second small regions or the correction amounts assigned in advance for each figure, and the correction amounts for the second small regions. This phenomenon is, for example, a proximity effect caused by emission of an electron beam.

The drawing unit 36 emits an electron beam to each of the two or more second small regions according to the emission amount for each of the two or more second small regions acquired by the emission amount acquisition unit 35. Note that the emission amount for each second small region is the emission amount acquired by the emission amount acquisition unit 35. The object on which drawing is to be performed is, for example, a photomask or a wafer. The drawing unit 36 can typically be realized using a field emission type, Schottky type, or thermionic type electron gun, an electron lens, a height detector, or the like. The cross-sectional shape of the electron beam emitted by the drawing unit 36 is, for example, rectangular or circular. The drawing unit 36 may draw figures using a plurality of beams simultaneously.

It is preferable that the drawing unit 36 apply bias processing on one or more pieces of figure information received by the figure information acceptance unit 21 to acquire information regarding biased figures. Thereafter, the emission amount acquisition unit 35 uses the information regarding the biased figures and the correction amounts for the two or more second small regions acquired by the correction amount acquisition unit 34 to acquire the emission amounts for the two or more second small regions. Specifically, correction is performed mainly in consideration of scattering of the electron beam in a narrower range. For calculations performed using density information regarding the second small regions, the influence range is usually on the order of mm, but for calculations performed in real time during drawing, the influence range is tens of micrometers or hundreds of nanometers (approximately 10 nm in some cases). The emission amount acquisition unit 35 inputs the "correction amount" for the second small area into a pre-stored arithmetic expression corresponding to this phenomenon, and acquires the emission amount by executing the arithmetic expression. Next, the drawing unit 36 emits an electron beam to each of the two or more second small regions according to the emission amount for each of the two or more second small regions acquired by the emission amount acquisition unit 35, to draw a figure.

The output unit 4 output various kinds of information. Examples of the various kinds of information include information indicating that drawing of a figure has been completed. Here, "output" is a concept that encompasses displaying on a display screen, projection using a projector, printing by a printer, the output of a sound, transmission to an external device, accumulation on a recording medium, delivery of a processing result to another processing device or another program, and the like.

It is preferable that the storage unit 1, the density set storage unit 11, and the differential information storage unit 12 are realized using a non-volatile recording medium, but they can be realized using a volatile recording medium.

There is no limitation on the process in which information is stored in the storage unit 1 or the like. For example, information may be stored in the storage unit 1 or the like via a recording medium, or information transmitted via a communication line or the like may be stored in the storage unit 1 or the like, or information input via an input device may be stored in the storage unit 1 or the like.

The acceptance unit 2 and the figure information acceptance unit 21 can be realized using a device driver for the input means such as a touch panel or a keyboard, or control software or the like for controlling the menu screen.

The bias amount acceptance unit 22, the processing unit 3, the first preprocessing unit 31, the second preprocessing unit 32, the density set acquisition unit 33, the correction amount acquisition unit 34, the emission amount acquisition unit 35, the density set readout part 331, the area change information acquisition part 332, and the density set acquisition part 333 can typically be realized using a processor, a memory, or the like. The processing procedures performed by the processing unit 3 and so on are typically realized using software, and the software is recorded on a recording medium such as a ROM. However, they may be realized using hardware (a dedicated circuit). Note that the processor is, for example, a CPU, an MPU, a GPU, or the like, and there is no limitation on the type thereof.

The output unit 4 may be regarded as including or not including an output device such as a display or a speaker. The output unit 4 can be realized using the driver software of the output device, the driver software of the output device and the output device, or the like.

The processing procedures performed by the drawing unit 36 are typically realized using software, and the software is recorded on a recording medium such as a ROM.

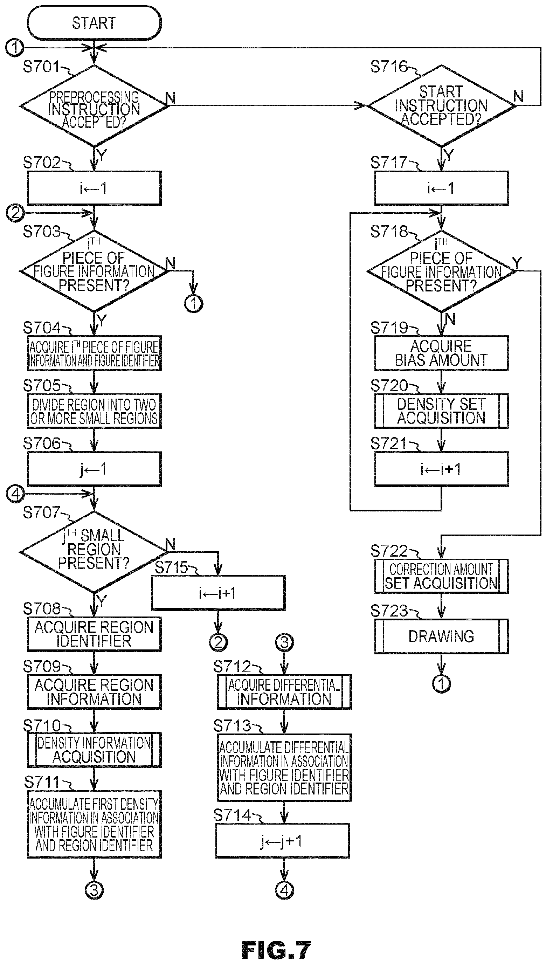

Next, examples of operations of the electron beam lithography apparatus A will be described with reference to the flowchart in FIG. 7.

(Step S701) The acceptance unit 2 judges whether or not a preprocessing instruction has been accepted. If a preprocessing instruction has been accepted, processing proceeds to step S702, and if a preprocessing instruction has not been accepted, processing proceeds to step S716.

(Step S702) The processing unit 3 substitutes 1 for a counter i.

(Step S703) The first preprocessing unit 31 judges whether or not the $i^{th}$ piece of figure information that is to be subjected to preprocessing is present. If the $i^{th}$ piece of figure information is present, processing proceeds to step S704, and if the $i^{th}$ piece of figure information is not present, processing returns to step S701. Note that the pieces of figure information to be subjected to preprocessing are stored in the storage unit 1 in association with figure identifiers, for example.

(Step S704) The first preprocessing unit 31 acquires the $i^{th}$ piece of figure information and the figure identifier from the storage unit 1, for example.

(Step S705) The first preprocessing unit 31 divides the region that contains the $i^{th}$ figure information into two or more small regions. Note that each of the small regions is referred to as a first small region. The processing performed to divide a region into two or more small regions is processing performed to acquire region information regarding each of the two or more first small regions in association with a region identifier. Note that the region identifier is information identifying a region (here, a first small region), and is an ID, for example. Region information is, for example, information specifying a rectangular region, and is constituted by, for example, two pieces of coordinate information (for example, $(x_1,y_1)(x_2,y_2)$). The two pieces of coordinate information are, for example, the upper left coordinates and the lower right coordinates of the rectangle. However, the region information may be, for example, information regarding the upper left coordinates, width, and height of the rectangle, and any structure may be used.

(Step S706) The first preprocessing unit 31 substitutes 1 for a counter j.

(Step S707) The first preprocessing unit 31 judges whether or not the $j^{th}$ first small region is present in the $i^{th}$ piece of figure information. If the $j^{th}$ first small region is present, processing proceeds to step S708, and if the $j^{th}$ first small region is not present, processing proceeds to step S715.

(Step S708) The first preprocessing unit 31 acquires a first small region identifier that is the identifier of the $j^{th}$ first small region in the $i^{th}$ piece of figure information.

(Step S709) The first preprocessing unit 31 acquires region information regarding the $j^{th}$ first small region in the $i^{th}$ piece of figure information.

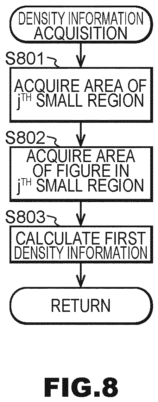

(Step S710) The first preprocessing unit 31 acquires first density information regarding the $j^{th}$ first small region in the $i^{th}$ piece of figure information. An example of such density information acquisition processing will be described with reference to the flowchart in FIG. 8.

(Step S711) The first preprocessing unit 31 accumulates the density information acquired in step S710, in association with the figure identifier of the $i^{th}$ figure information and the first small region identifier of the $j^{th}$ first small region. Note that the density information may be stored in the storage unit 1 or in an external device (not shown) or the like.

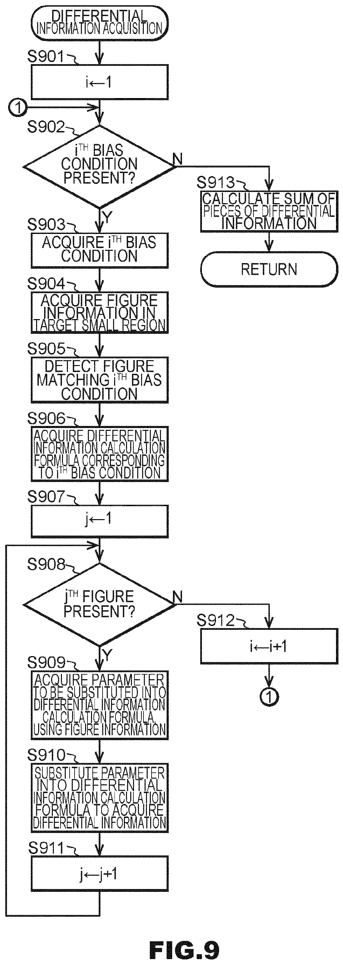

(Step S712) The second preprocessing unit 32 acquires differential information. An example of such differential information acquisition processing will be described with reference to the flowchart in FIG. 9.

(Step S713) The second preprocessing unit 32 accumulates the differential information acquired in step S712, in association with the figure identifier of the $i^{th}$ figure information and the first small region identifier of the $j^{th}$ first small region. Note that the differential information may be stored in the storage unit 1 or in an external device (not shown) or the like.

(Step S714) The first preprocessing unit 31 increments the counter j by 1. Processing returns to step S707.

(Step S715) The processing unit 3 increments the counter i by 1. Processing returns to step S703.

(Step S716) The acceptance unit 2 judges whether or not a start instruction has been accepted. If a start instruction has been accepted, processing proceeds to step S717, and if a start instruction has not been accepted, processing returns to step S701.

(Step S717) The processing unit 3 substitutes 1 for a counter i.

(Step S718) The density set acquisition unit 33 judges whether or not the $i^{th}$ piece of figure information that is to be subjected to drawing processing is present. If the $i^{th}$ piece of figure information is present, processing proceeds to step S704, and if the $i^{th}$ piece of figure information is not present, processing returns to step S701. Note that the piece of figure information to be drawn is stored in the storage unit 1 in association with figure identifiers, for example. Alternatively, the piece of figure information to be drawn is contained in a start instruction.

(Step S719) The bias amount acceptance unit 22 acquires a bias amount. Note that the bias amount may differ according to figure information. The bias amount may differ according the figure in figure information.

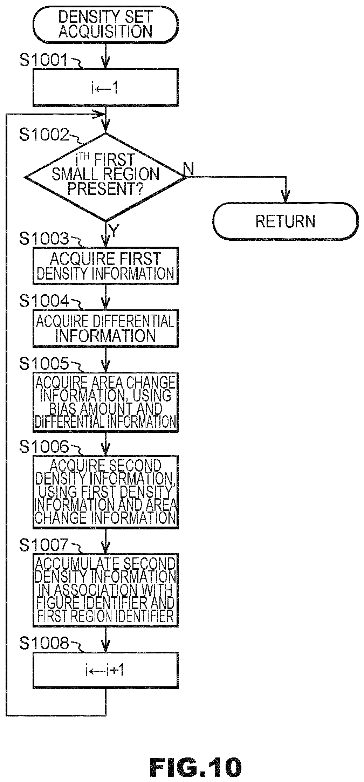

(Step S720) The density set acquisition unit 33 acquires a second density set. An example of such density information acquisition processing will be described with reference to the flowchart in FIG. 10.

(Step S721) The processing unit 3 increments the counter i by 1. Processing returns to step S718.

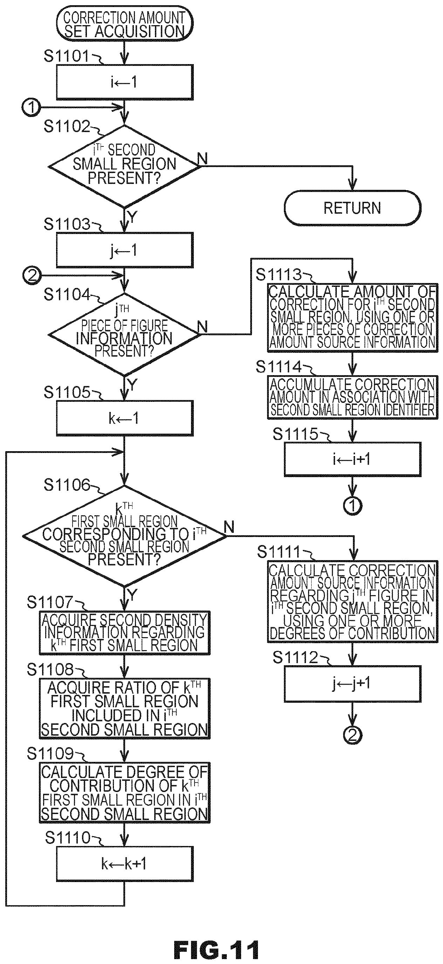

(Step S722) The correction amount acquisition unit 34 acquires a correction amount set. An example of such correction amount acquisition will be described with reference to the flowchart in FIG. 11.

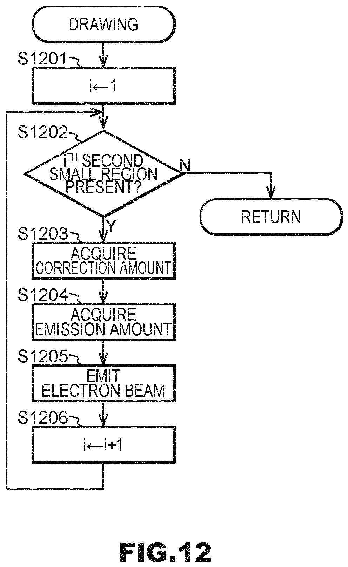

(Step S723) The drawing unit 36 performs drawing processing, using the correction amount set acquired in step S722. Processing returns to step S701. An example of drawing processing will be described with reference to the flowchart in FIG. 12.

Note that, in the flowchart in FIG. 7, processing ends when the power is turned off or an interruption occurs to end the processing.

An example of the density information acquisition processing in step S710 will be described with reference to the flowchart in FIG. 8.

(Step S801) The first preprocessing unit 31 acquires the area (referred to as a first area, for example) of the $j^{th}$ small region in the $i^{th}$ piece of figure information. Note that such an area is stored in the storage unit 1, for example. Such an area can be acquired from region information regarding the $j^{th}$ small region.

(Step S802) The first preprocessing unit 31 acquires the area (referred to as a second area, for example) of the area occupied by the figure in the $j^{th}$ small region in the $i^{th}$ figure information. The first preprocessing unit 31 calculates the area occupied by the figure in the $j^{th}$ small region, typically using region information regarding the $j^{th}$ small region and the figure information. Such a technique is a well-known technique.

(Step S803) The first preprocessing unit 31 calculates first density information, using the first area acquired in step S801 and the second area acquired in step S802. Processing returns to higher-level processing.

Note that the first preprocessing unit 31 calculates density information using, for example, an arithmetic expression "the density information = the second area divided by the first area". The first preprocessing unit 31 may use the second area as density information. Density information need only be information specifying how much of the figure is included in the $j^{th}$ small region.

Next, an example of the differential information acquisition processing in step S712 will be described with reference to the flowchart in FIG. 9.

(Step S901) The second preprocessing unit 32 substitutes 1 for a counter i.

(Step S902) The second preprocessing unit 32 judges whether or not an $i^{th}$ bias condition is present in the storage unit 1. If the $i^{th}$ bias condition is present, processing proceeds to step S903, and if the $i^{th}$ bias condition is not present, processing proceeds to step S913.

(Step S903) The second preprocessing unit 32 acquires the $i^{th}$ bias condition from the storage unit 1.

(Step S904) The second preprocessing unit 32 acquires a piece of figure information in the target small region, of the target figure information.

(Step S905) The second preprocessing unit 32 detects figures that match the $i^{th}$ bias condition in the small region, using the figure information in the small region.

(Step S906) The second preprocessing unit 32 acquires a differential information calculation formula corresponding to the $i^{th}$ bias condition from the storage unit 1.

(Step S907) The second preprocessing unit 32 substitutes 1 for a counter J.

(Step S908) The second preprocessing unit 32 judges whether or not the $j^{th}$ figure is present in the figures detected in step S905. If the $j^{th}$ figure is present, processing proceeds to step S909, and if the $j^{th}$ figure is not present, processing proceeds to step S912.

(Step S909) The second preprocessing unit 32 acquires one or more parameters to be substituted into the differential information calculation formula acquired in step S906, using information regarding the $j^{th}$ figure of the figure information in the small region to be processed. Note that examples of the one or more parameters include the length of the diagonal line in the small region, the angle of the diagonal line in the small region, and the angle of the corner in the small region.

(Step S910) The second preprocessing unit 32 substitutes the one or more parameters acquired in step S909 into the differential information calculation formula acquired in step S906, executes the differential information calculation formula to acquire differential information, and accumulates the differential information in a buffer (not shown).

(Step S911) The second preprocessing unit 32 increments the counter j by 1. Processing returns to step S908.

(Step S912) The second preprocessing unit 32 increments the counter i by 1. Processing returns to step S902.

(Step S913) The second preprocessing unit 32 calculates the sum of the pieces of differential information accumulated in the buffer in step S910. Note that the sum of such pieces of differential information is the differential information regarding the first small region of interest. If no differential information has been accumulated in the buffer in step S910, differential information is "0".

Next, an example of the density set acquisition processing in step S720 will be described with reference to the flowchart in FIG. 10.

(Step S1001) The density set acquisition unit 33 substitutes 1 for a counter i.

(Step S1002) The density set readout part 331 judges whether or not the $i^{th}$ first small region is present in the figure information to be processed. If the $i^{th}$ first small region is present, processing proceeds to step S1003, and if the $i^{th}$ first small region is not present, processing returns to higher-level processing.

(Step S1003) The density set readout part 331 acquires the figure identifier of the figure information to be processed and the first density information paired with the first small region identifier of the $i^{th}$ first small region from the density set storage unit 11.

(Step S1004) The area change information acquisition part 332 acquires the figure identifier of the figure information to be processed and the differential information paired with the first small region identifier of the $i^{th}$ first small region from the differential information storage unit 12.

(Step S1005) The area change information acquisition part 332 acquires area change information, using the bias amount acquired by the bias amount acceptance unit 22 and the differential information acquired in step S1004. Note that the area change information acquisition part 332 calculates area change information using, for example, an arithmetic expression "the area change information = the bias amount $\times$ the differential information".

(Step S1006) The density set acquisition unit 33 acquires second density information regarding the $i^{th}$ first small region in the figure information to be processed, using the first density information acquired in step S1003 and the area change information acquired in step S1005. Note that the density set acquisition unit 33 calculates second density information using, for example, an arithmetic expression "the second density information = the first density information + the area change information".

(Step S1007) The density set acquisition unit 33 accumulates the second density information acquired in step S1006 in association with the figure identifier of the figure information to be processed and the first small region identifier of the $i^{th}$ first small region. Note that the second density information is stored in the storage unit 1, for example, but there is no limitation.

(Step S1008) The density set acquisition unit 33 increments the counter i by 1. Processing returns to step S1002.

Next, an example of the correction amount set acquisition in step S722 will be described with reference to the flowchart in FIG. 11.

(Step S1101) The correction amount acquisition unit 34 substitutes 1 for a counter i.

(Step S1102) The correction amount acquisition unit 34 judges whether or not the $i^{th}$ second small region is present. If the $i^{th}$ second small region is present, processing proceeds to step S1103, and if the $i^{th}$ second small region is not present, processing returns to higher-level processing.

(Step S1103) The correction amount acquisition unit 34 substitutes 1 for a counter j.

(Step S1104) The correction amount acquisition unit 34 judges whether or not the $j^{th}$ piece of figure information to be drawn is present. If the $j^{th}$ piece of figure information is present, processing proceeds to step S1105, and if the $j^{th}$ piece of figure information is not present, processing proceeds to step S1113.

(Step S1105) The correction amount acquisition unit 34 substitutes 1 for a counter k.

(Step S1106) The correction amount acquisition unit 34 judges whether or not the $k^{th}$ first region corresponding to the $i^{th}$ second small region is present. If the $k^{th}$ first region is present, processing proceeds to step S1107, and if the $k^{th}$ first region is not present, processing proceeds to step S1111.

(Step S1107) The correction amount acquisition unit 34 acquires second density information regarding the $k^{th}$ first region.

(Step S1108) The correction amount acquisition unit 34 acquires the ratio of the $k^{th}$ first region included in the $i^{th}$ second small region.

(Step S1109) The correction amount acquisition unit 34 calculates the degree of contribution, using the second density information acquired in step S1107 and the ratio acquired in step S1108. Note that the degree of contribution is information indicating the degree of contribution of the correction amount of the $k^{th}$ first region in the $i^{th}$ second small region. The correction amount acquisition unit 34 calculates the degree of contribution, using an arithmetic expression "the degree of contribution = the second density information $\times$ the ratio".

(Step S1110) The correction amount acquisition unit 34 increments the counter k by 1. Processing returns to step S1106.

(Step S1111) The correction amount acquisition unit 34 calculates correction amount source information for the $j^{th}$ figure in the $i^{th}$ second small region, using the one or more degrees of contribution calculated in step S1109. Note that the correction amount source information is calculated using an increasing function that employs the one or more degrees of contribution as parameters. Correction amount source information is, for example, the sum of one or more degrees of contribution.

(Step S1112) The correction amount acquisition unit 34 increments the counter j by 1. Processing returns to step S1104.

(Step S1113) The correction amount acquisition unit 34 calculates the correction amount for the $i^{th}$ second small region, using the one or more pieces of correction amount source information calculated in step S1111. Note that the correction amount acquisition unit 34 calculates the correction amount using an increasing function that employs the one or more pieces of correction amount source information as parameters. The correction amount acquisition unit 34 calculates the correction amount using, for example, an arithmetic expression "the correction amount = the sum of the one or more pieces of correction amount source information".

(Step S1114) The correction amount acquisition unit 34 accumulates the correction amount calculated in step S1113, in association with the second small region identifier of the $i^{th}$ second small region. Note that the correction amount is accumulated in the storage unit 1, for example, but there is no limitation.

(Step S1115) The correction amount acquisition unit 34 increments the counter i by 1. Processing returns to step S1102.

Next, an example of the drawing processing in step S723 will be described with reference to the flowchart in FIG. 12.

(Step S1201) The drawing unit 36 substitutes 1 for a counter i.

(Step S1202) The drawing unit 36 judges whether or not the $i^{th}$ second small region in which a figure is to be drawn is present. If the $i^{th}$ second small region is present, processing proceeds to step S1203, and if the $i^{th}$ second small region is not present, processing returns to higher-level processing.

(Step S1203) The drawing unit 36 acquires a correction amount that is paired with the second small region identifier of the $i^{th}$ second small region. Note that, for example, the drawing unit 36 reads out the correction amount paired with the second small region identifier of the $i^{th}$ second small region from the storage unit 1.

(Step S1204) The drawing unit 36 calculates an emission amount, using the correction amount acquired in step S1203. Note that, for example, the drawing unit 36 calculates an emission amount, using an increasing function that employs the correction amount as a parameter.

(Step S1205) The drawing unit 36 emits an electron beam to the $i^{th}$ second small region according to the emission amount calculated in step S1204.

(Step S1206) The drawing unit 36 increments the counter i by 1. Processing returns to step S1202.

Hereinafter, specific examples of operations of the electron beam lithography apparatus A according to the present embodiment will be described. Two specific examples will be described below.

Specific Example 1

Specific Example 1 is a first example of preprocessing that is performed by the electron beam lithography apparatus A, and is an example of processing that is performed to acquire a density set (density map).

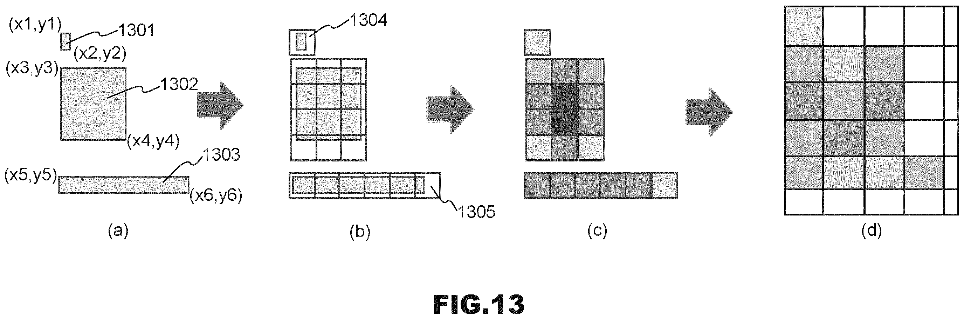

It is now assumed that figure information specifying three rectangular figures shown in FIG. 13(a) is stored in the storage unit 1 of the electron beam lithography apparatus A. It is assumed that the pieces of figure information in FIG. 13(a) are, for example, figure information regarding a figure 1301 (x1,y1)(x2,y2), figure information regarding a figure 1302(x3,y3)(x4,y4), and figure information regarding figure 1303 (x5,y5)(x6,y6).

It is assumed that the user inputs a preprocessing instruction to the electron beam lithography apparatus A. Next, the acceptance unit 2 accepts the preprocessing instruction.

Next, the first preprocessing unit 31 divides the region including the pieces of figure information in FIG. 13(a) into two or more small regions (see FIG. 13(b)). Note that each of the small regions is referred to as a first small region. It is assumed that the first preprocessing unit 31 acquires pieces of small region information (the upper left coordinates and the lower right coordinates of a rectangle) regarding each first small region in FIG. 13(b). Note that examples of the first small regions are 1304 and 1305 shown in FIG. 13.

Next, the first preprocessing unit 31 calculates the area occupied by the figure in each first small region, using region information regarding each first small region and figure information. The first preprocessing unit 31 also acquires the area of each first small region, from area information regarding the first small region. Note that the first preprocessing unit 31 may read out the area of each first small region from the storage unit 1.

Next, the first preprocessing unit 31 calculates density information regarding each first small region, using the area occupied by the figure in each first small region and the area of the first small region. For example, the first preprocessing unit 31 calculates density information, using, for example, an arithmetic expression "the density information = the area occupied by the figure in the first small region divided by the area of the first small region".

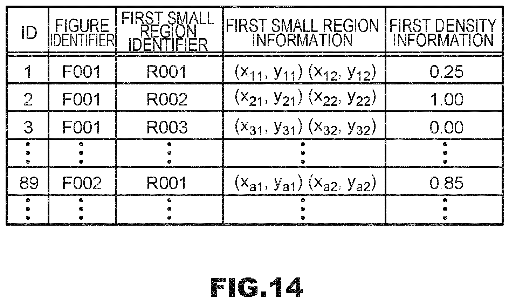

Thereafter, the first preprocessing unit 31 accumulates the first density information in the density set storage unit 11 in association with the figure identifier specifying the figure information and the first small region identifier of each first small region. An example of the first density map, which is a set of such pieces of first density information, is shown in FIG. 14. In FIG. 14, there are many records each containing "ID", "figure identifier", "first small region identifier", "first small region information", and "first density information". The first density map in FIG. 14 is illustrated in FIG. 13(c).

Note that, as described with reference to the flowchart in FIG. 7, the first density map in FIG. 14 is used to create a correction amount set (a correction map), which is created when a figure is to be drawn. The correction map is illustrated in FIG. 13(d). Furthermore, as described with reference to the flowchart in FIG. 7, the emission amount for each second small region is determined using the correction map, and an electron beam is emitted according to the emission amount.

As described above, by preparing the density map in advance, it is possible to speed up the drawing of figures with the electron beam.

Specific Example 2

Specific Example 2 is a first example of preprocessing that is performed by the electron beam lithography apparatus A, and is an example of processing that is performed to acquire differential information regarding each first small region, and acquire a density set (density map) using the differential information.

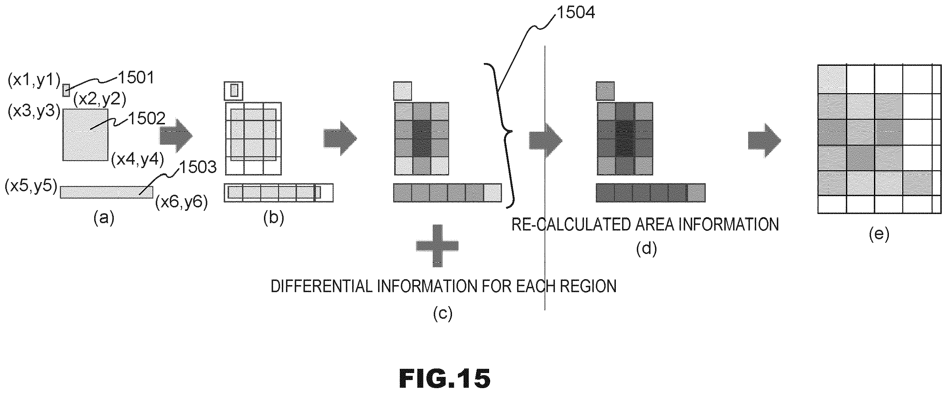

It is now assumed that figure information containing three rectangular figures shown in FIG. 15(a) is stored in the storage unit 1 of the electron beam lithography apparatus A. It is assumed that the pieces of figure information in FIG. 15(a) are, for example, figure information regarding a figure 1501 (x1,y1)(x2,y2), figure information regarding a figure 1502(x3,y3)(x4,y4), and figure information regarding figure 1503 (x5,y5)(x6,y6).

It is assumed that the user inputs a preprocessing instruction to the electron beam lithography apparatus A. Next, the acceptance unit 2 accepts the preprocessing instruction.

Next, the first preprocessing unit 31 acquires a first density map 1504 containing first density information regarding two or more first small regions through the processing described in Specific Example 1.

Next, as described with reference to the flowchart in FIG. 9, the second preprocessing unit 32 acquires a differential information calculation formula corresponding to the bias conditions that the figure information in the two or more first small regions match, acquires one or more parameters that are to be substituted into the differential information calculation formula, from the figure information, substitutes the one or more parameters into the differential information calculation formula, and executes the differential information calculation formula to calculate the differential information. Thereafter, the second preprocessing unit 32 accumulates pieces of differential information for each piece of figure information and each first small region, in the differential information storage unit 12.

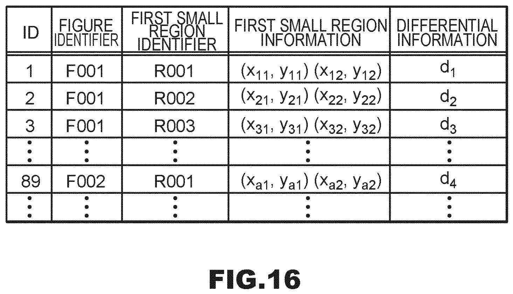

An example of such a differential information set is shown in FIG. 16. In FIG. 16, there are many records each containing "ID", "figure identifier", "first small region identifier", "first small region information", and "differential information". Note that the pieces of differential information "$d_1$", "$d_2$", "$d_3$", "$d_4$", and so on in FIG. 16 are numerical values.

Note that the differential information set in FIG. 16 is used to create a correction amount set (a correction map), which is created when a figure is to be drawn, as described with reference to the flowchart in FIG. 7. That is to say, as described with reference to the flowchart in FIG. 10, second density information is acquired for each of the first small regions shown in FIG. 15(d), using the first density map 1504 created by the first preprocessing unit 31 and the differential information regarding each first small region acquired by the second preprocessing unit 32 (see FIG. 15(c)). Note that the second density information set for each of the two or more first small regions is the second density map.

Thereafter, as described with reference to the flowchart in FIG. 7, a correction amount set (a correction map), which is created when a figure is to be drawn, is created using the second density information for each of the first small regions shown in FIG. 15(d) (the second density map). The concept of the correction map is illustrated in FIG. 15(e). Furthermore, as described with reference to the flowchart in FIG. 7, the emission amount for each second small region is determined using the correction map, and an electron beam is emitted according to the emission amount.

As described above, by preparing the differential information set in advance, it is possible to speed up the drawing of figures with the electron beam.

As described above, with present embodiment, it is possible to acquire an appropriate emission amount at a high speed when using an electron beam to draw a figure.

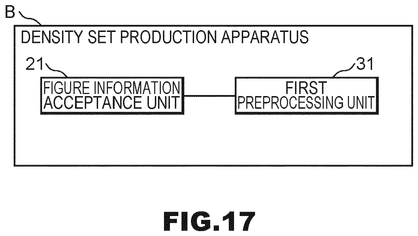

Note that, in the present embodiment, the apparatus that creates the first density map may be formed as an apparatus different from the electron beam lithography apparatus. A block diagram for a density set production apparatus B, which is an apparatus in the aforementioned case, is shown in FIG. 17.

The density set production apparatus B includes: a figure information acceptance unit 21 that accepts one or more pieces of figure information; and a first preprocessing unit 31 that acquires, for each of two or more first small regions divided from a figure region that is a region specified by the figure information, first density information that is based on areas occupied by a figure indicated by the figure information, in the two or more first small regions, acquires a first density set that is a set of pieces of first density information, for each piece of figure information, and accumulates the first density set.

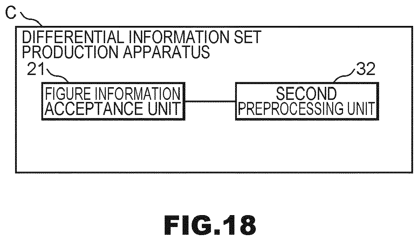

Note that, in the present embodiment, the apparatus that creates the differential information set may be formed as an apparatus different from the electron beam lithography apparatus. A block diagram for a differential information set production apparatus C, which is an apparatus in the aforementioned case, is shown in FIG. 18.

The differential information set production apparatus C includes: a figure information acceptance unit 21 that accepts one or more pieces of figure information; and a second preprocessing unit 32 that calculates differential information specifying a change in an area per unit amount of bias for each of the one or more pieces of figure information and for each of two or more first small regions, and accumulates the differential information.

Furthermore, the processing in the present embodiment may be realized using software. This software may be distributed through software downloading or the like. Also, this software may be recorded on a recording medium such as a CD-ROM and distributed. Note that the same applies to the other embodiments in the present description. The software that realizes the electron beam lithography apparatus A according to the present embodiment is the program described below. That is to say, this program is a program that enables a computer that can access a density set storage unit that stores, for each of one or more pieces of figure information, a first density set that is a set of pieces of first density information corresponding to areas occupied by a figure indicated by the piece of figure information in two or more first small regions divided from a figure region specified by the piece of figure information, and is a set of pieces of first density information respectively for the two or more first small regions, to function as: a figure information acceptance unit that accepts one or more pieces of figure information; a density set acquisition unit that acquires first density sets respectively corresponding to the one or more pieces of figure information accepted by the figure information acceptance unit, from the density set storage unit; a correction amount acquisition unit that acquires correction amounts that are correction amounts corresponding to the one or more first density sets for each of the one or more pieces of figure information, and are correction amounts for the two or more second small regions; an emission amount acquisition unit that acquires, for the two or more second small regions, emission amounts of an electron beam with intensities corresponding to the correction amounts for the two or more second small regions acquired by the correction amount acquisition unit; and a drawing unit that emits an electron beam to each of the two or more second small regions according to the emission amounts for the two or more second small regions, acquired by the emission amount acquisition unit.

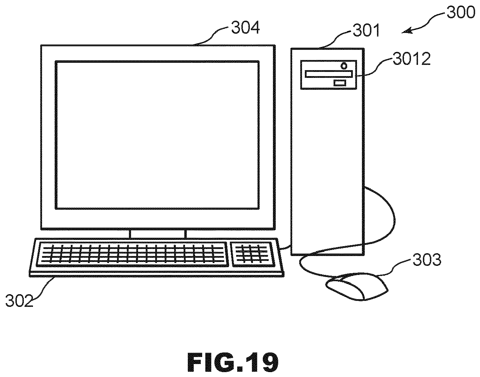

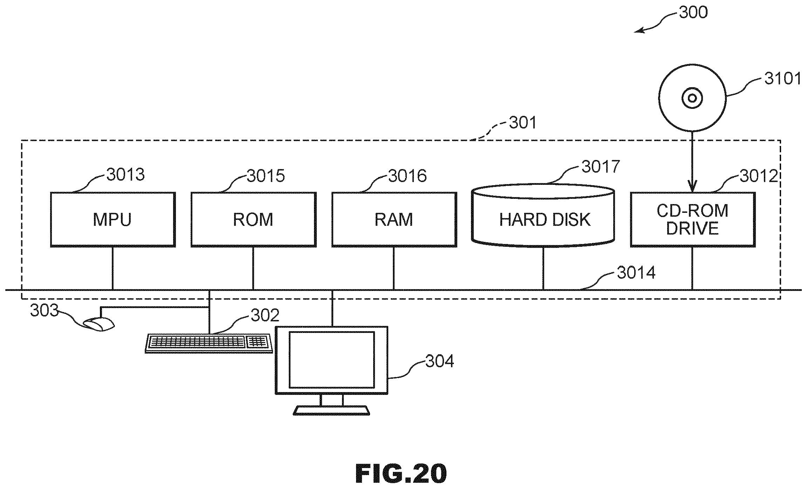

FIG. 19 shows an example of the external appearance of a computer that executes the program described in the present specification and realizes the electron beam lithography apparatus A according to the various embodiments described above. The above-described embodiments can be realized using computer hardware and a computer program that runs thereon. FIG. 19 is an overview diagram for this computer system 300, and FIG. 20 is a block diagram for the system 300.

In FIG. 19, the computer system 300 includes a computer 301 that includes a CD-ROM drive, a keyboard 302, a mouse 303, and a monitor 304.

In FIG. 20, the computer 301 includes, in addition to the CD-ROM drive 3012, an MPU 3013, a bus 3014 that is connected to the CD-ROM drive 3012 and so on, a ROM 3015 for storing programs such as a boot-up program, a RAM 3016 that is connected to the MPU 3013 and is used to temporarily store application program instructions and provide a temporary storage space, and a hard disk 3017 for storing application programs, system programs, and data. Here, although not shown in the drawings, the computer 301 may further include a network card that provides connection to a LAN.

The program that enables the computer system 300 to perform the functions of the electron beam lithography apparatus A according to the above-described embodiments may be stored in the CD-ROM 3101, inserted into the CD-ROM drive 3012, and furthermore transferred to the hard disk 3017. Alternatively, the program may be transmitted to the computer 301 via a network (not shown) and stored on the hard disk 3017. The program is loaded into the RAM 3016 when the program is to be executed. The program may be directly loaded from the CD-ROM 3101 or the network.

The program does not necessarily have to include an operating system (OS), a third-party program, or the like that enables the computer 301 to perform the functions of the electron beam lithography apparatus A according to the above-described embodiments. The program need only contain the part of the instruction that calls an appropriate function (module) in a controlled manner to achieve a desired result. How the computer system 300 works is well known and the detailed descriptions thereof will be omitted.

In the above-described program, the step of transmitting information, the step of receiving information and so on do not include processing performed by hardware, for example, processing performed by a modem or an interface card in the step of transmitting (processing that can only be performed by hardware).

There may be a single or multiple computers executing the above-described program. That is to say, centralized processing or distributed processing may be performed.

Also, as a matter of course, in each of the above-described embodiments, two or more communication means that are present in one device may be physically realized using one medium.

In each of the above-described embodiments, each kind of processing may be realized as centralized processing that is performed by a single device, or distributed processing that is performed by multiple devices.

As a matter of course, the present invention is not limited to the above-described embodiments, and various changes are possible, and such variations are also included within the scope of the present invention.

Industrial Applicability

As described above, the electron beam lithography apparatus according to the present invention achieves the effect of being able to acquire an appropriate emission amount at a high speed when using an electron beam to draw a figure, is useful as an electron beam lithography apparatus.

**Claims**

1. An electron beam lithography apparatus comprising:

   a density set storage unit that stores, for each of one or more pieces of figure information, a first density set that is a set of pieces of first density information corresponding to areas occupied by a figure indicated by the piece of figure information in two or more first small regions divided from a figure region specified by the piece of figure information, and is a set of pieces of first density information for the two or more first small regions;
   a figure information acceptance unit that accepts one or more pieces of figure information;
   a density set acquisition unit that acquires first density sets respectively corresponding to the one or more pieces of figure information accepted by the figure information acceptance unit, from the density set storage unit;
   a correction amount acquisition unit that acquires correction amounts that are correction amounts corresponding to the one or more first density sets for each of the one or more pieces of figure information, and are correction amounts for the two or more second small regions;
   an emission amount acquisition unit that acquires, for the two or more second small regions, emission amounts of an electron beam with intensities corresponding to the correction amounts for the two or more second small regions acquired by the correction amount acquisition unit; and
   a drawing unit that emits an electron beam to each of the two or more second small regions according to the emission amounts for the two or more second small regions, acquired by the emission amount acquisition unit.

2. The electron beam lithography apparatus according to claim 1,

   wherein the density set acquisition unit includes:

      a density set readout part that acquires first density sets respectively corresponding to the one or more pieces of figure information accepted by the figure information acceptance unit, from the density set storage unit;
      an area change information acquisition part that acquires, for a first small region that matches a bias condition regarding a figure in the first small region, of the two or more first small regions, area change information that is based on the figure in the first small region; and
      a density set acquisition part that acquires, for each of the one or more pieces of figure information, a second density set that is a set of pieces of second density information respectively for the one or more first small regions, using the pieces of first density information for the one or more first small regions contained in the first density sets acquired by the density set readout part, and the area change information regarding the one or more first small regions, acquired by the area change information acquisition part, and

   the correction amount acquisition unit uses the one or more second density sets acquired by the density set acquisition part, to acquire the correction amounts for the two or more second small regions.

3. The electron beam lithography apparatus according to claim 2, further comprising:

   a differential information storage unit that stores, for each of one or more pieces of figure information and for each of two or more first small regions, differential information specifying a change in an area per unit amount of bias; and

a bias amount acceptance unit that accepts an amount of bias,

wherein the area change information acquisition part acquires, for the first small region that matches the bias condition, area change information for each of the one or more pieces of figure information, using differential information associated with the first small region and the bias amount accepted by the bias amount acceptance unit.

4. The electron beam lithography apparatus according to claim 3, further comprising:
a second preprocessing unit that calculates differential information specifying a change in an area per unit amount of bias for each of the one or more pieces of figure information and for each of the two or more first small regions, and accumulates the differential information in the differential information storage unit.

5. The electron beam lithography apparatus according to claim 4,

   wherein the electron beam lithography apparatus stores a differential information calculation formula for calculating differential information, for each of one or more bias conditions, and
   the second preprocessing unit acquires, for each of the one or more pieces of figure information and for each of the two or more first small regions, a differential information calculation formula corresponding to the matching bias condition, calculates differential information using the differential information calculation formula, and accumulates the differential information in the differential information storage unit.

6. The electron beam lithography apparatus according to claim 3,

   wherein the bias condition is that the figure in the first small region includes a horizontal line or a vertical line, and
   the area change information acquisition part acquires, with respect to the horizontal line or the vertical line, area change information indicating a size that is proportional to the bias amount.

7. The electron beam lithography apparatus according to claim 3,

   wherein the bias condition is that the figure in the first small region includes a diagonal line, and
   the area change information acquisition part acquires the bias amount, angle information regarding an angle of the diagonal line, and length information regarding a length of the diagonal line in the first small region, and calculates the area change information using the bias amount, the angle information, and the length information.

8. The electron beam lithography apparatus according to claim 3,

   wherein the bias condition is that the figure in the first small region includes a corner formed by an intersection of two straight lines, and
   the area change information acquisition part calculates areas of a parallelogram and two triangles created by extending the two straight lines by a length corresponding to the bias amount, and calculates the area change information, using the three areas.

9. The electron beam lithography apparatus according to claim 1, further comprising
a first preprocessing unit that acquires, for each of two or more first small regions divided from a figure region that is a region specified by the figure information, first density information that is based on areas occupied by a figure indicated by the figure information, in the two or more first small regions, acquires a first density set that is a set of pieces of first density information, for each piece of figure information, and accumulates the first density set in the density set storage unit.

10. The electron beam lithography apparatus according to claim 1,

   wherein the drawing unit performs bias processing on the one or more pieces of figure information accepted by the figure information acceptance unit, to acquire information regarding a biased figure,
   the emission amount acquisition unit acquires an emission amount of an electron beam for each of the two or more second small regions, using the information regarding the biased figure and the correction amount for the two or more second small regions, acquired by the correction amount acquisition unit, and
   the drawing unit emits an electron beam to each of the two or more second small regions according to the emission amount for each of the two or more second small regions acquired by the emission amount acquisition unit, to draw a figure.

11. An electron lithography method realized using a density set storage unit that stores, for each of one or more pieces of figure information, a first density set that is a set of pieces of first density information corresponding to areas occupied by a figure indicated by the piece of figure information in two or more first small regions divided from a figure region specified by the piece of figure information, and is a set of pieces of first density information for the two or more first small regions; a figure information acceptance unit, a density set acquisition unit, a correction amount acquisition unit, an emission amount acquisition unit, and a drawing unit, the electron lithography method comprising:

a figure information acceptance step in which the figure information acceptance unit accepts one or more pieces of figure information;

a density set acquisition step in which the density set acquisition unit acquires first density sets respectively corresponding to the one or more pieces of figure information accepted by the figure information acceptance unit, from the density set storage unit;

a correction amount acquisition step in which the correction amount acquisition unit acquires correction amounts that are correction amounts corresponding to the one or more first density sets for each of the one or more pieces of figure information, and are correction amounts for the two or more second small regions;

an emission amount acquisition step in which the emission amount acquisition unit acquires, for the two or more second small regions, emission amounts of an electron beam with intensities corresponding to the correction amounts for the two or more second small regions acquired by the correction amount acquisition unit; and

a drawing step in which the drawing unit emits an electron beam to each of the two or more second small regions according to the emission amounts for the two or more second small regions, acquired by the emission amount acquisition unit.

12. A recording medium having recorded thereon a program that enables a computer that can access a density set storage unit that stores, for each of one or more pieces of figure information, a first density set that is a set of pieces of first density information corresponding to areas occupied by a figure indicated by the piece of figure information in two or more first small regions divided from a figure region specified by the piece of figure information, and is a set of pieces of first density information respectively for the two or more first small regions, to function as:

a figure information acceptance unit that accepts one or more pieces of figure information;

a density set acquisition unit that acquires first density sets respectively corresponding to the one or more pieces of figure information accepted by the figure information acceptance unit, from the density set storage unit;

a correction amount acquisition unit that acquires correction amounts that are correction amounts corresponding to the one or more first density sets for each of the one or more pieces of figure information, and are correction amounts for the two or more second small regions;

an emission amount acquisition unit that acquires, for the two or more second small regions, emission amounts of an electron beam with intensities corresponding to the correction amounts for the two or more second small regions acquired by the correction amount acquisition unit; and

a drawing unit that emits an electron beam to each of the two or more second small regions according to the emission amounts for the two or more second small regions, acquired by the emission amount acquisition unit.

**FIG.1**

**FIG.2**

Y component of bias

301

X component of bias

θ

Area contribution by
Y component

Area contribution by
X component

**FIG.3**

**FIG.4**

**FIG.5**

**FIG.6**

**FIG.7**

DENSITY INFORMATION
ACQUISITION

S801

ACQUIRE AREA OF
j$^{TH}$ SMALL REGION

S802

ACQUIRE AREA
OF FIGURE IN
j$^{TH}$ SMALL REGION

S803

CALCULATE FIRST
DENSITY INFORMATION

RETURN

# FIG.8

**FIG.9**

```
        ╭─────────────────╮
        │   DENSITY SET    │
        │   ACQUISITION    │
        ╰─────────────────╯
                 │
S1001            ▼
        ┌─────────────────┐
        │      i←1         │
        └─────────────────┘
                 │
        ┌───────▶│
        │        ▼
S1002   │      ╱─────────╲
        │     ╱ iTH FIRST  ╲      N
        │    ◀ SMALL REGION ─────────────┐
        │     ╲ PRESENT?  ╱               │
        │      ╲─────────╱                ▼
        │        │ Y              ╭─────────────────╮
S1003   │        ▼                │     RETURN      │
        │  ┌─────────────────┐    ╰─────────────────╯
        │  │  ACQUIRE FIRST  │
        │  │DENSITY INFORMATION│
        │  └─────────────────┘
        │        │
S1004   │        ▼
        │  ┌─────────────────┐
        │  │ACQUIRE DIFFERENTIAL│
        │  │   INFORMATION   │
        │  └─────────────────┘
        │        │
S1005   │        ▼
        │  ┌─────────────────┐
        │  │ACQUIRE AREA CHANGE│
        │  │INFORMATION, USING │
        │  │  BIAS AMOUNT AND  │
        │  │DIFFERENTIAL INFORMATION│
        │  └─────────────────┘
        │        │
S1006   │        ▼
        │  ┌─────────────────┐
        │  │  ACQUIRE SECOND │
        │  │DENSITY INFORMATION,│
        │  │USING FIRST DENSITY│
        │  │INFORMATION AND AREA│
        │  │CHANGE INFORMATION │
        │  └─────────────────┘
        │        │
S1007   │        ▼
        │  ┌─────────────────┐
        │  │ACCUMULATE SECOND│
        │  │DENSITY INFORMATION│
        │  │IN ASSOCIATION WITH│
        │  │FIGURE IDENTIFIER AND│
        │  │FIRST REGION IDENTIFIER│
        │  └─────────────────┘
        │        │
S1008   │        ▼
        │  ┌─────────────────┐
        │  │     i←i+1       │
        │  └─────────────────┘
        │        │
        └────────┘
```

# FIG.10

35

FIG.11

DRAWING

S1201 → i ← 1

S1202 → i$^{TH}$ SECOND SMALL REGION PRESENT? —N→ RETURN

Y

S1203 → ACQUIRE CORRECTION AMOUNT

S1204 → ACQUIRE EMISSION AMOUNT

S1205 → EMIT ELECTRON BEAM

S1206 → i ← i+1

**FIG.12**

FIG.13

| ID | FIGURE IDENTIFIER | FIRST SMALL REGION IDENTIFIER | FIRST SMALL REGION INFORMATION | FIRST DENSITY INFORMATION |
|---|---|---|---|---|
| 1 | F001 | R001 | $(x_{11}, y_{11}) (x_{12}, y_{12})$ | 0.25 |
| 2 | F001 | R002 | $(x_{21}, y_{21}) (x_{22}, y_{22})$ | 1.00 |
| 3 | F001 | R003 | $(x_{31}, y_{31}) (x_{32}, y_{32})$ | 0.00 |
| ⋮ | ⋮ | ⋮ | ⋮ | ⋮ |
| 89 | F002 | R001 | $(x_{a1}, y_{a1}) (x_{a2}, y_{a2})$ | 0.85 |
| ⋮ | ⋮ | ⋮ | ⋮ | ⋮ |

# FIG.14

(x1,y1) 1501
(x2,y2)
(x3,y3) 1502
(x4,y4) 1503
(x5,y5)
(x6,y6)

(a)

(b)

DIFFERENTIAL INFORMATION FOR EACH REGION

(c)

1504

RE-CALCULATED AREA INFORMATION

(d)

(e)

**FIG.15**

| ID | FIGURE IDENTIFIER | FIRST SMALL REGION IDENTIFIER | FIRST SMALL REGION INFORMATION | DIFFERENTIAL INFORMATION |
|---|---|---|---|---|
| 1 | F001 | R001 | $(x_{11}, y_{11}) (x_{12}, y_{12})$ | $d_1$ |
| 2 | F001 | R002 | $(x_{21}, y_{21}) (x_{22}, y_{22})$ | $d_2$ |
| 3 | F001 | R003 | $(x_{31}, y_{31}) (x_{32}, y_{32})$ | $d_3$ |
| ⋮ | ⋮ | ⋮ | ⋮ | ⋮ |
| 89 | F002 | R001 | $(x_{a1}, y_{a1}) (x_{a2}, y_{a2})$ | $d_4$ |
| ⋮ | ⋮ | ⋮ | ⋮ | ⋮ |

# FIG.16

B

DENSITY SET PRODUCTION APPARATUS

21

| FIGURE INFORMATION ACCEPTANCE UNIT | FIRST PREPROCESSING UNIT |

31

**FIG.17**

C

DIFFERENTIAL INFORMATION SET
PRODUCTION APPARATUS

21

FIGURE INFORMATION
ACCEPTANCE UNIT

32

SECOND
PREPROCESSING UNIT

## FIG.18

FIG.19

**FIG.20**

## INTERNATIONAL SEARCH REPORT

| International application No. |
|---|
| **PCT/JP2021/048171** |

### A. CLASSIFICATION OF SUBJECT MATTER

*H01J 37/305*(2006.01)i; *G03F 7/20*(2006.01)i; *H01L 21/027*(2006.01)i
FI:   H01L21/30 541E; G03F7/20 504; H01J37/305 B

According to International Patent Classification (IPC) or to both national classification and IPC

### B. FIELDS SEARCHED

Minimum documentation searched (classification system followed by classification symbols)

H01L21/027; H01L21/30

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | JP 11-26360 A (SONY CORP) 29 January 1999 (1999-01-29)<br>paragraphs [0022], [0025], fig. 3 | 1-12 |
| Y | JP 2012-243939 A (NUFLARE TECHNOLOGY INC) 10 December 2012 (2012-12-10)<br>paragraphs [0041], [0068]-[0069], fig. 5 | 1-12 |
| A | JP 2016-201472 A (NUFLARE TECHNOLOGY INC) 01 December 2016 (2016-12-01)<br>entire text, all drawings | 1-12 |
| A | JP 2012-212792 A (NUFLARE TECHNOLOGY INC) 01 November 2012 (2012-11-01)<br>entire text, all drawings | 1-12 |
| A | JP 2007-115891 A (HITACHI HIGH-TECHNOLOGIES CORP) 10 May 2007 (2007-05-10)<br>entire text, all drawings | 1-12 |
| A | JP 2013-171946 A (NUFLARE TECHNOLOGY INC) 02 September 2013 (2013-09-02)<br>entire text, all drawings | 1-12 |
| A | JP 2012-253316 A (NUFLARE TECHNOLOGY INC) 20 December 2012 (2012-12-20)<br>entire text, all drawings | 1-12 |

☐ Further documents are listed in the continuation of Box C.    ☑ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **01 March 2022** | **15 March 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
Information on patent family members

International application No.

**PCT/JP2021/048171**

| Patent document cited in search report | | | Publication date (day/month/year) | Patent family member(s) | Publication date (day/month/year) |
|---|---|---|---|---|---|
| JP | 11-26360 | A | 29 January 1999 | (Family: none) | |
| JP | 2012-243939 | A | 10 December 2012 | (Family: none) | |
| JP | 2016-201472 | A | 01 December 2016 | US 2016/0300687 A1<br>entire text, all drawings<br>KR 10-2016-0121419 A<br>TW 201703091 A | |
| JP | 2012-212792 | A | 01 November 2012 | (Family: none) | |
| JP | 2007-115891 | A | 10 May 2007 | (Family: none) | |
| JP | 2013-171946 | A | 02 September 2013 | (Family: none) | |
| JP | 2012-253316 | A | 20 December 2012 | US 2012/0286174 A1<br>entire text, all drawings | |

Form PCT/ISA/210 (patent family annex) (January 2015)

**EP 4 362 057 A1**

**Patent documents cited in the description**

- JP 6283180 B